(19) Europäisches Patentamt
European Patent Office
Office européen des brevets

(11) **EP 4 447 315 A1**

(12) **EUROPEAN PATENT APPLICATION**
published in accordance with Art. 153(4) EPC

(43) Date of publication:
**16.10.2024 Bulletin 2024/42**

(21) Application number: **22903519.1**

(22) Date of filing: **07.12.2022**

(51) International Patent Classification (IPC):
**H02S 30/10** (2014.01)

(52) Cooperative Patent Classification (CPC):
**H02S 30/00; F24S 25/632; F24S 25/636; H02S 30/10;** Y02E 10/50

(86) International application number:
**PCT/CN2022/137252**

(87) International publication number:
**WO 2023/104098 (15.06.2023 Gazette 2023/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 07.12.2021 CN 202123060966 U
07.05.2022 CN 202210493719
07.05.2022 CN 202221081122 U

(71) Applicant: **Trina Solar Co., Ltd
Changzhou, Jiangsu 213031 (CN)**

(72) Inventor: **JIANG, Ahua
hangzhou, Jiangsu 213031 (CN)**

(74) Representative: **Nederlandsch Octrooibureau
P.O. Box 29720
2502 LS The Hague (NL)**

(54) **SECTIONAL MATERIAL PRESSING MEMBER, SECTIONAL MATERIAL, PHOTOVOLTAIC MODULE FRAME, PHOTOVOLTAIC SYSTEM AND ASSEMBLING METHOD THEREOF**

(57) The present invention provides a sectional material pressing member, a sectional material, a photovoltaic module frame, a photovoltaic system and an assembling method thereof. The sectional material pressing member is used for combining and fixing a sectional material. A side groove is formed in the side surface of the sectional material, one side of the sectional material pressing member is provided with a first combining portion used for combining a side groove of one sectional material, the opposite other side of the sectional material pressing member is provided with a second combining portion used for combining a side groove of another sectional material, and the sectional material pressing member has a penetrating fastening hole. The sectional material pressing member in the present invention can enhance the strength of the sectional material, is low in cost, and is convenient in mounting to the sectional material.

FIG. 6A

EP 4 447 315 A1

**Description**

Technical Field

The present application mainly relates to installation accessories of photovoltaic modules, and in particular to a sectional material pressing member, sectional material, photovoltaic module frame, photovoltaic system and assembly method thereof.

Background

Sectional materials are objects with a certain geometric shape made of materials with certain strength and toughness through rolling, extrusion, casting and other processes. Due to the limitations of the manufacturing process, the cross-sectional shape of a sectional material is generally fixed, and its shape and thickness are uniform in each section in the length direction. When selecting sectional materials, sectional materials that match the shape, material, mechanical properties, etc. according to the actual installation requirements are generally chose. In practical application scenarios, the external forces borne by different positions of the sectional material are not the same, which leads to deformation or even tearing at some positions of the sectional material. To avoid such deformation and tearing, in the prior art, designs are generally adopted to strengthen the entire sectional material, such as thickening the sectional material as a whole, which causes resource waste to a certain extent.

Sectional materials can be used to form various frames, which are installed on the periphery of the workpiece to support, fix and protect the corresponding workpiece.

As a specific application scenario, solar photovoltaic modules are fixed with laminates including solar cells through photovoltaic module frames. The function of module frames is to enhance the mechanical strength of modules, seal the edges of the laminates, and fix the laminates on brackets to form a solar photovoltaic module, referred to as a photovoltaic module or module. Therefore, the strength of the module frames determines the overall strength of the photovoltaic module.

The main part of an existing photovoltaic module frame is generally made of aluminum alloy and is integrally formed by extrusion. Due to the aforementioned reasons, the same type of frame sectional materials have a uniform cross-sectional shape and thickness. The cross-sectional shape and thickness of the long and short sides of the module frame may be different, but they are consistent between the long and long sides, as well as the short and short sides. In most cases, the cross-sectional shape and thickness between the long and short sides are also consistent. This would lead to the fact that when designing the module frame, the strength of the frame needs to be designed according to the maximum stress point, so that the whole frame meets the strength requirement of the maximum stress point, causing redundancy in the strength of other parts of the frame, and ultimately resulting in cost waste.

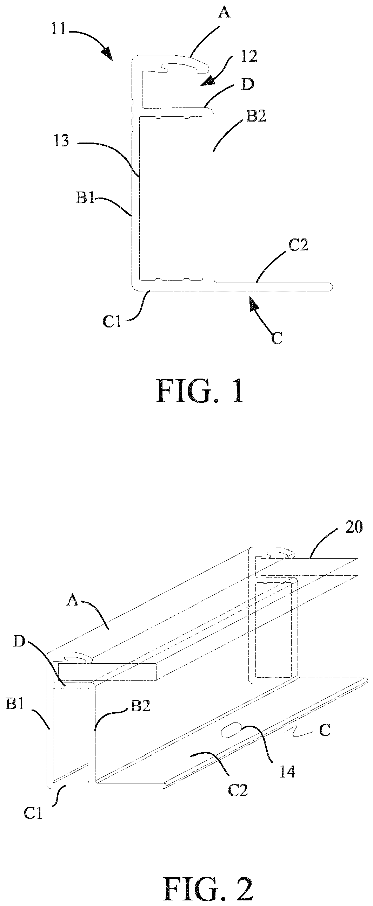

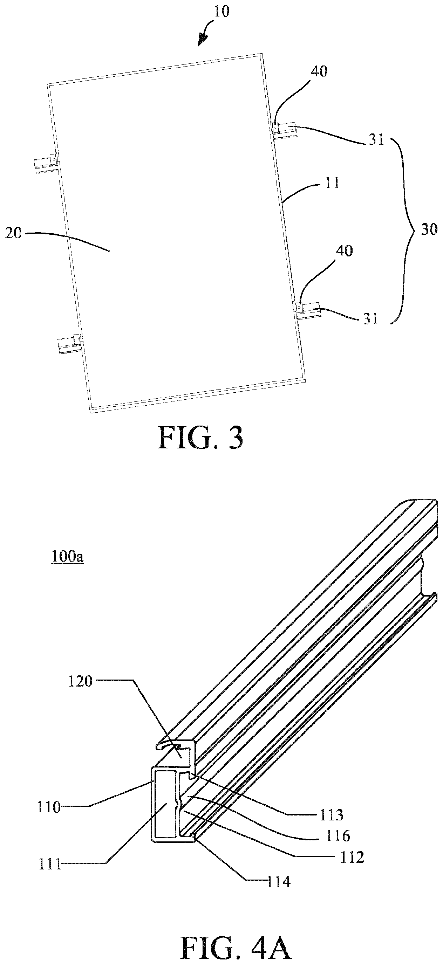

FIG. 1 shows a cross-sectional view of a sectional material, and FIG 2 and FIG 3 show schematic diagrams of the sectional material being used to assemble photovoltaic modules. As shown in the figures, the sectional material 11 has an A surface, a B1 surface, a B2 surface, a C surface and a D surface. A groove 12 for supporting the photovoltaic module 20 is formed between the A surface and the D surface, and a cavity 13 is formed between the B1 surface, B2 surface, C surface and D surface. The portion of the C surface located at the bottom of the cavity 13 is the C1 surface, and the C1 surface extends inwards to form the C2 surface. The C surface is the contact surface with the photovoltaic bracket 30 when the photovoltaic module 20 is installed. Generally speaking, there are bolt holes 14 on the C2 surface, which can be used to install the photovoltaic module 20 on the bracket 30 with fasteners (not shown). In more cases, the pressing members 40 and fasteners are used on the A surface and B1 surface to mount the photovoltaic module 20 on the bracket 30. Judging from the cost structure of existing sectional materials, B1 surface, B2 surface and C2 surface constitute the main part of the raw material cost of sectional materials.

FIG. 3 shows a schematic diagram of the photovoltaic module installed on the purlin of the photovoltaic bracket. As shown in FIG. 3, when the photovoltaic module 20 is installed, the long side sectional material 11 of the module frame 10 and the purlin 31 of the bracket 30 are installed vertically. The width of the purlins 31 is generally 40-60mm, and the position of the two purlins 31 is generally in the area of 1/8 to 1/4 of the long side of the module. When the photovoltaic module 20 is stressed, the stress in this area (the position where the module frame and the purlin contact and the nearby position) of the module frame is largest, but the stress in other parts of the module frame is relatively small. In the prior art, when designing the frame, the mechanical properties of the frame are designed with reference to the part with the greatest stress, so that corresponding load redundancy is formed in the part with smaller stress.

In addition, in the bolt hole installation method in the prior art, the installation position is generally located on the inner extension surface (the C2 surface) of the bottom of the frame. Due to the need to reduce the cost of photovoltaic modules in recent years, the wall thickness and width of the C2 surface have been reduced as much as possible, which has resulted in a reduction in the strength of the module mounting surface, and bolt holes often fail due to force deformation or pull-through. This technical problem can be solved by increasing the thickness of the bottom of the frame or widening the bottom of the frame. However, under the existing module frame structure, it is necessary to strengthen the long side along the length direction or at least widen the C2 surface, which will lead to a significant increase in cost and a greater economic burden.

Summary

The technical problem to be solved by the present invention is to provide a sectional material pressing member, a sectional material, a photovoltaic module frame, a photovoltaic system and an assembly method thereof that can enhance the strength of the sectional material and are low-cost and easy to install.

In order to solve the above technical problems, the present application provides a sectional material pressing member used for combining and fixing a sectional material with a side groove in a side surface, one side of the sectional material pressing member is provided with a first combining portion used for combining a side groove of one sectional material, an opposite other side of the sectional material pressing member is provided with a second combining portion for combining a side groove of another sectional material, and the sectional material pressing member comprises a penetrating fastening hole.

In one embodiment of the present invention, an upper end of a mouth of the side groove comprises a first convex strip, the first combining portion and the second combining portion respectively include a first side and a second side and a third side respectively connecting two ends of the first side, wherein a first protrusion is provided between the first side and the second side, and the first protrusion is adapted to snap into a top surface of the side groove when the sectional material pressing member is combined with the sectional material.

In one embodiment of the present invention, a lower end of the mouth of the side groove comprises a second convex strip, and a second protrusion is provided between the first side and the third side, when the sectional material pressing member is combined with the sectional material, the second protrusion snaps into a bottom surface of the side groove.

In one embodiment of the present invention, the first protrusion crosses the first convex strip and snaps into the top surface of the side groove, and the second protrusion crosses the second convex strip and snaps into the bottom surface of the side groove.

In one embodiment of the present invention, the second side comprises a third protrusion spaced opposite to the first protrusion, and a first groove is formed between the first protrusion and the third protrusion to cooperate with the first convex strip.

In one embodiment of the present invention, the third side has a fourth protrusion spaced opposite to the second protrusion, and a second groove is formed between the second protrusion and the fourth protrusion to fit with the second convex strip.

In one embodiment of the present invention, a height of an end surface of the second protrusion of the second combining portion relative to a bottom surface of the sectional material pressing member is higher than a height of an end surface of the second protrusion of the first combining portion relative to the bottom surface of the sectional material pressing member.

In one embodiment of the present invention, the second side comprises a third protrusion spaced opposite to the first protrusion, and a first groove is formed between the first protrusion and the third protrusion to fit with the first convex strip.

In one embodiment of the present invention, a second groove is formed on a position of the third side between the first combining portion and the second protrusion, the third side comprises a fourth protrusion spaced opposite to the second protrusion at the second combining portion, and a third groove is formed between the second protrusion and the fourth protrusion of the second combining portion to fit with the second convex strip.

In one embodiment of the present invention, the sectional material pressing member further comprises an elastic strip formed in the third groove of the second combining portion, when the sectional material pressing member is combined with another sectional material, the elastic strip of the second combining portion contacts the second convex strip.

In one embodiment of the present invention, a lower end of the mouth of the side groove is flat, wherein a connection point between the first side and the third side is flat, and fits the bottom surface of the mouth of the side groove when the sectional material pressing member is combined with the sectional material.

In one embodiment of the present invention, the second side comprises a third protrusion spaced opposite to the first protrusion, and a first groove is formed between the first protrusion and the third protrusion to cooperate with the first convex strip.

In one embodiment of the present invention, the third side comprises a fourth protrusion adjacent to the connection point, when the sectional material pressing member is combined with the sectional material, an end surface of the fourth protrusion is flush with a bottom surface of the sectional material.

In one embodiment of the present invention, the sectional material pressing member comprises a cavity inside.

In one embodiment of the present invention, a bottom surface of the first groove is inclined upwards in a direction from outside to inside, and an inclination angle thereof relative to the bottom surface of the sectional material pressing member is greater than or equal to an inclination angle of an end surface of the first convex strip relative to a bottom surface of the sectional material.

In one embodiment of the present invention, an outer surface of the third protrusion is inclined inwards in a direction from bottom to top, and an inclination angle thereof relative to the first side is greater than or equal to an inclination angle of an end surface of the first protrusion relative to the bottom surface of the sectional material.

In one embodiment of the present invention, an inclination angle of the bottom surface of the first groove relative to the bottom surface of the sectional material pressing member is between 10-20°.

In one embodiment of the present invention, an inclination angle of an outer side of the third protrusion relative to the first side is between 10-20°.

In one embodiment of the present invention, a vertical distance between an end surface of the first protrusion and an end surface of the second protrusion is less than the sum of a width of the mouth of the side groove and a height of the first convex strip.

In one embodiment of the present invention, a vertical distance between the second protrusion's end surface and the bottom surface of the sectional material pressing member is less than or equal to a vertical distance between the bottom surface of the side groove and a bottom surface of the sectional material.

In one embodiment of the present invention, a vertical distance between an end surface of the second protrusion of the second combining portion and the bottom surface of the sectional material pressing member is greater than or equal to a vertical distance between an end surface of the mouth of the side groove and a bottom surface of the sectional material.

In one embodiment of the present invention, a distance between an outer endpoint of the first groove and the second protrusion's end surface is less than or equal to a width of the mouth of the side groove.

In one embodiment of the present invention, a vertical distance between a floating outer endpoint of the first groove of the second combining portion and an end surface of the second protrusion of the second combining portion is less than or equal to a width of the mouth of the side groove.

In one embodiment of the present invention, a height difference between the floating outer endpoint and an outer endpoint of the first groove of the second combining portion is equal to the height of the second convex strip.

In one embodiment of the present invention, when the sectional material pressing member is combined with the sectional material, the gap between the first side and a side surface of the side groove is less than or equal to 2mm.

Another aspect of the present invention also provides a sectional material which comprises an outer frame and a bearing part, and the outer frame comprises a cavity, a side surface of the outer frame comprises a side groove for installing a sectional material pressing member, and an upper end of a mouth of the side groove comprises a first convex strip, the bearing part is located on the outer frame and is used to carry the workpiece to be installed.

In one embodiment of the present invention, a bottom of the outer frame comprises an opening, and the sectional material further includes a reinforcement inserted into the cavity from the opening.

In one embodiment of the present invention, an outer surface of a lower end of the mouth of the side groove and an outer surface of the upper end of the mouth are on a same plane.

In one embodiment of the present invention, a lower end of the mouth of the side groove is flat.

In one embodiment of the present invention, a lower end of the mouth of the side groove comprises a second convex strip.

In one embodiment of the present invention, an end surface of the second convex strip is inclined downwards in a direction from inside to outside relative to a bottom surface of the sectional material.

In one embodiment of the present invention, an inclination angle of an end surface of the second convex strip relative to the bottom surface of the sectional material is between 10-20°.

In one embodiment of the present invention, a top surface of the side groove and an end surface of the first convex strip' are inclined upwards in the direction from inside to outside, wherein assuming that a thickness of the first convex strip is *b,* a height of the first convex strip is *e,* a depth of the side groove is c, a width of the mouth of the side groove is H, an inclination angle of the end surface of the first convex strip relative to a bottom surface of the sectional material is α, an inclination angle of the top surface of the side groove relative to the bottom surface of the sectional material is γ, then:

$$\alpha = argtan\left(\frac{b+c}{H+e}\right),$$

$$\gamma \geq \alpha.$$

In one embodiment of the present invention, the inclination angles $\alpha$ and $\gamma$ are between 10-20°.

In one embodiment of the present invention, an inclination angle of the top surface of the side groove and the end surface of the first convex strip relative to bottom surface of the sectional material is 0.

In one embodiment of the present invention, the sectional material pressing member comprises a combining portion combined with the side groove, and the combining portion includes a first side, and a second side and a third side respectively connecting two ends of the first side, a first protrusion is provided at the connection point between the first side and the second side, a second protrusion is provided at the connection point between the first side and the third, when the sectional material is combined with the sectional material pressing member, the first protrusion snaps into the top surface of the side groove, and the second protrusion snaps into the bottom surface of the side groove.

In one embodiment of the present invention, a vertical distance between the bottom surface of the side groove and the bottom surface of the sectional material is greater than or equal to a vertical distance between the end surface of the second protrusion and the bottom surface of the sectional material pressing member.

In one embodiment of the present invention, the second side of the sectional material pressing member comprises a third protrusion spaced opposite to the first protrusion, and a first groove is formed between the first protrusion and the third protrusion to cooperate with the first convex strip, wherein a bottom surface of the first groove is inclined upwards in a direction from outside to inside, and an inclination angle thereof relative to the bottom surface of the sectional material pressing member is greater than or equal to an inclination angle of an end surface of the first convex strip relative to a bottom surface of the sectional material.

In one embodiment of the present invention, an outer surface of the third protrusion is inclined inwards in a direction from bottom to top, and an inclination angle the bottom surface of relative to the first side is greater than or equal to an inclination angle of an end surface of the first protrusion relative to the bottom surface of the sectional material.

In one embodiment of the present invention, a height of the first convex strip is 2.5-3.5mm.

In one embodiment of the present invention, a height of the second convex strip is 0.8-1.5mm.

In one embodiment of the present invention, the second side comprises a third protrusion spaced opposite to the first protrusion, and a first groove is formed between the first protrusion and the third protrusion to fitwith the first convex strip, a width of the mouth of the side groove is greater than or equal to a distance between an outer endpoint of the first groove and the end surface of the second protrusion.

In one embodiment of the present invention, when the sectional material pressing member is combined with the sectional material, the gap between the first side and a side surface of the side groove is less than or equal to 2mm.

In one embodiment of the present invention, a side surface of the side groove has a lateral protrusion.

Another aspect of the present invention also provides a sectional material which comprises an outer frame and a bearing part, and the outer frame comprises a cavity, a side surface of the outer frame comprises a side groove for installing a sectional material pressing member, and an upper end of a mouth of the side groove comprises a first convex strip, the bearing part is located on the outer frame and is used to carry a workpiece to be installed, a top surface of the side groove and an end surface of the first convex strip are inclined upwards in a direction from inside to outside, wherein assuming that a thickness of the first convex strip is *b,* a height of the first convex strip is *e,* a depth of the side groove is *c*, a width of the mouth of the side groove is *H*, an inclination angle of the end surface of the first convex strip relative to the sectional material's bottom surface is $\alpha$, an inclination angle of the end surface of the side groove relative to the bottom surface of the sectional material is $\gamma$, then:

$$\alpha = argtan\left(\frac{b+c}{H+e}\right),$$

$$\gamma \geq \alpha.$$

In one embodiment of the present invention, a lower end of the mouth of the side groove also comprises a second convex strip.

In one embodiment of the present invention, an end surface of the second convex strip is inclined downwards in a direction from inside to outside relative to the bottom surface of the sectional material.

In one embodiment of the present invention, the sectional material pressing member comprises a combining portion combined with the side groove, and the combining portion includes a first side, and a second side and a third side respectively connecting two ends of the first side, a first protrusion is provided at the connection point between the first side and the second side, a second protrusion is provided at the connection point between the first side and the third, when the sectional material is combined with the sectional material pressing member, the first protrusion snaps into the top surface of the side groove, and the second protrusion snaps into a bottom surface of the side groove.

In one embodiment of the present invention, a vertical distance between the bottom surface of the side groove and the bottom surface of the sectional material is greater than or equal to a vertical distance between an end surface of the second protrusion and the bottom surface of the sectional material pressing member.

In one embodiment of the present invention, the second side of the sectional material pressing member comprises a third protrusion spaced opposite to the first protrusion, and a first groove is formed between the first protrusion and the third protrusion to fit with the first convex strip, wherein a bottom surface of the first groove is inclined upwards in a direction from outside to inside, and an inclination angle thereof relative to the bottom surface of the sectional material pressing member is greater than or equal to an inclination angle of an end surface of the first convex strip relative to the bottom surface of the sectional material.

In one embodiment of the present invention, an outer surface of the third protrusion is inclined inwards in a direction from bottom to top, and an inclination angle thereof relative to the first side is greater than or equal to an inclination angle of an end surface of the first protrusion relative to the second side.

In one embodiment of the present invention, a height of the first convex strip is 2.5-3.5mm.

In one embodiment of the present invention, a height of the second convex strip is 0.8-1.5mm.

In one embodiment of the present invention, a width of the mouth of the side groove is greater than or equal to a distance between an outer endpoint of the first groove and the second protrusion's end surface.

In one embodiment of the present invention, when the sectional material pressing member is combined with the sectional material, a gap between the first side and a side surface of the side groove is less than or equal to 2mm.

In one embodiment of the present invention, a side surface of the side groove comprises a lateral protrusion.

Another aspect of the present invention also provides a photovoltaic module frame, which comprises: a plurality of sectional materials as previously described, each of the sectional material comprising a bearing part for carrying the workpiece to be installed, each of the sectional material comprising a side groove on a side surface, and at least one sectional material pressing member is installed on the side groove.

In one embodiment of the present invention, the plurality of sectional materials surround an enclosed area for carrying a photovoltaic module.

In one embodiment of the present invention, at least some of the plurality of sectional materials are arranged adjacently, and the adjacently arranged sectional materials share the sectional material pressing member.

In one embodiment of the present invention, a length of the sectional material pressing member is smaller than a length of the sectional material.

Another aspect of the present invention also provides a photovoltaic system, which comprises: the photovoltaic module frame as described above; a plurality of photovoltaic modules arranged in the photovoltaic module frame.

Another aspect of the present invention also provides a method of assembling a photovoltaic system, which includes following steps: installing a first combining portion of a first sectional material pressing member in a side groove of a sectional material with a photovoltaic module; snapping the side groove of the sectional material with the first sectional material pressing member with a second combining portion of a second sectional material pressing member which is installed on a bracket by a fastener; and installing the first sectional material pressing member on the bracket through the fastener; wherein the first sectional material pressing member and the second sectional material pressing member are the sectional material pressing members as described above, the sectional material is the sectional material as described above.

In one embodiment of the present invention, when installing the first combining portion of the first sectional material pressing member in the side groove of the sectional material with the photovoltaic module, install the first sectional material pressing member into the side groove at a predetermined angle relative to the sectional material, and then rotate the first sectional material pressing member until a bottom surface of the first sectional material pressing member is parallel to a bottom surface of the sectional material.

In one embodiment of the present invention, when snapping the side groove of the sectional material with the second combining portion of the second sectional material pressing member, snap the sectional material with the second combining portion at a predetermined angle relative to the second sectional material pressing member, and then rotate the sectional material until a bottom surface of the sectional material is parallel to a bottom surface of the second sectional material pressing member.

In one embodiment of the present invention, the predetermined angle is between 10-20°.

In one embodiment of the present invention, when an upper end of the mouth of the side groove of the sectional material comprises a first convex strip and a lower end of the mouth of the side groove comprises a second convex strip, the fastener does not tighten the second sectional material pressing member so that the second sectional material pressing member has an amount of up and down movement equal to a height of the second convex strip, and after the side groove of the sectional material is engaged with the second combining portion of the second sectional material pressing member, fasten the fastener.

In one embodiment of the present invention, when an upper end of the mouth of the side groove of the sectional material comprises a first convex strip and a lower end of the mouth of the side groove comprises a second convex strip, and an end surface of the second protrusion of the second combining portion of the second sectional material pressing member is higher than an end surface of the second protrusion of the first combining portion, fasten the second sectional material pressing member with the fastener before snapping the side groove of the sectional material with the second combining portion of the second sectional material pressing member.

In one embodiment of the present invention, in the step of snapping the side groove of the sectional material with a photovoltaic module with the second combining portion of the second sectional material pressing member, firstly lift the sectional material so that a lower endpoint of the first convex strip of the sectional material contacts a floating outer endpoint of the first groove of the second combining portion, then snap the side groove of the sectional material with the second combining portion of the second sectional material pressing member, the floating outer endpoint of the first groove is higher than an outer endpoint of the first groove.

In one embodiment of the present invention, when an upper end of the mouth of the side groove of the sectional material which is combined with the second combining portion of the first sectional material pressing member has a first convex strip, and a lower end of the mouth of the side groove has a second convex strip, the first sectional material pressing member is not tightened when installing the first sectional material pressing member on the bracket by the fastener.

In one embodiment of the present invention, when an upper end of the mouth of the side groove of the sectional material which is combined with the second combining portion of the first sectional material pressing member has a first convex strip, and a lower end of the mouth of the side groove has a second convex strip, and the end surface of the second protrusion of the second combining portion of the second sectional material pressing member is higher than the end surface of the second protrusion of the first combining portion, directly tighten the first sectional material pressing member when installing the first sectional material pressing member on the bracket by the fastener.

In one embodiment of the present invention, when the sectional material pressing member is combined with the first sectional material or the second sectional material, a gap between a side surface of the side groove and a side surface of the first sectional material pressing member or the second sectional material pressing member is less than or equal to 2mm.

Another aspect of the present invention also provides a method of assembling a photovoltaic system, which includes following steps: installing a first combining portion of a sectional material pressing member into a side groove of a first sectional material with a photovoltaic module; installing the sectional material pressing member on a bracket by a fastener; and snapping a side groove of a second sectional material with a second combining portion of the sectional material pressing member; wherein the first sectional material pressing member and the second sectional material pressing member are the sectional material pressing members as described above, the sectional material is the sectional material as described above.

In one embodiment of the present invention, when installing the first combining portion of the sectional material pressing member in the side groove of the sectional material with the photovoltaic module, install the sectional material pressing member into the side groove at a predetermined angle relative to the sectional material, and then rotate the sectional material pressing member until a bottom surface of the sectional material pressing member is parallel to a bottom surface of the sectional material.

In one embodiment of the present invention, when snapping the side groove of the second sectional material with the second combining portion of the sectional material pressing member, snap the second sectional material with the second combining portion at a predetermined angle relative to the sectional material pressing member, and then rotate the second sectional material until a bottom surface of the second sectional material is parallel to a bottom surface of the sectional material pressing member.

In one embodiment of the present invention, the predetermined angle is between 10-20°.

In one embodiment of the present invention, when the first sectional material or the second sectional material is combined with the sectional material pressing member, a gap between a side surface of the side groove of the first sectional material or the second sectional material and a side surface of the sectional material pressing member is less than or equal to 2mm.

Brief Description of the Drawings

The drawings are included to provide a further understanding of the present application, and they are included and constitute a part of the present application, the drawings show the embodiments of the present application, and serving to explain the principles of the present application together with the description. In the drawings:

FIG. 1 is a schematic structural diagram of a sectional material used for photovoltaic module frames;
FIG. 2 is a schematic diagram of the sectional material in FIG. 1 used to form a photovoltaic module;
FIG. 3 is a schematic diagram of the photovoltaic module of FIG. 2 installed on the purlins of the photovoltaic bracket;
FIG. 4A is a schematic three-dimensional structural diagram of a sectional material used for photovoltaic module frames according to the first embodiment of the present application;

FIG. 4B is a schematic cross-sectional view of a sectional material used for a photovoltaic module frame according to the first embodiment of the present application;

FIG. 4C is a variation of a sectional material used for the frame of a photovoltaic module according to the first embodiment of the present application;

FIG. 5A is a schematic three-dimensional structural diagram of a sectional material pressing member according to the first embodiment of the present application;

FIG. 5B is a schematic cross-sectional view of a sectional material pressing member according to the first embodiment of the present application;

FIG. 5C is a variation of a sectional material pressing member according to the first embodiment of the present application;

FIG. 6A is a schematic three-dimensional structural diagram of the assembly method of a sectional material and sectional material pressing members according to the first embodiment of the present application;

FIG. 6B is a schematic cross-sectional view of the assembly method of a sectional material and sectional material pressing members according to the first embodiment of the present application;

FIGS. 7A-7C are schematic diagrams of the assembly steps of a sectional material and sectional material pressing members according to the first embodiment of the present application;

FIG. 8 is a three-dimensional schematic diagram of photovoltaic module installation according to an embodiment of the present application;

FIG. 9 is a schematic cross-sectional view of a sectional material used for a photovoltaic module frame according to the second embodiment of the present application;

FIG. 10 is a schematic cross-sectional view of a sectional material pressing member according to the second embodiment of the present application;

FIG. 11 is a schematic cross-sectional view of the assembly method of a sectional material and sectional material pressing members according to the second embodiment of the present application;

FIGS. 12A-12B are schematic diagrams of the assembly steps of a sectional material and sectional material pressing members according to the second embodiment of the present application;

FIG. 13A is a schematic three-dimensional structural diagram of a sectional material pressing member with an elastic strip according to the third embodiment of the present application;

FIG. 13B is a schematic cross-sectional view of a sectional material pressing member with an elastic strip according to the third embodiment of the present application;

FIG. 14A is a schematic three-dimensional structural diagram of the assembly method of a sectional material and a sectional material pressing member with an elastic strip according to the third embodiment of the present application;

FIG. 14B is a schematic cross-sectional view of the assembly method of a sectional material and a sectional material pressing member with an elastic strip according to the third embodiment of the present application;

FIGS. 15A-15C are schematic diagrams of the assembly steps of a sectional material and a sectional material pressing member with an elastic strip according to the third embodiment of the present application;

FIG. 16A is a schematic structural diagram of a sectional material according to the fourth embodiment of the present application;

FIG. 16B is a schematic assembly diagram of a sectional material and a sectional material pressing member according to the fourth embodiment of the present application;

FIGS. 17A-17B are schematic structural diagrams of a sectional material according to an embodiment of the present application.

The figures in the figure are marked as follows:

| sectional material | 100a, 100a', 100b, 100c |
| --- | --- |
| outer frame | 110 |
| cavity | 111 |
| side groove | 112 |
| first convex strip | 113 |
| second convex strip | 114 |
| lower end of the mouth | 114a |
| opening | 115 |
| lateral protrusion | 116 |

(continued)

| bottom surface of the sectional material | 117 |
|---|---|
| reinforcement | 118 |
| support part | 118a |
| bottom edge | 118b |
| bearing part | 120 |
| sectional material pressing member | 200a, 200a1, 200a2, 200b, 200c, 200c1, 200c2 |
| fastening hole | 210 |
| fastener | 211 |
| screw | 211a |
| screw nut | 211b |
| first combining portion | 220 |
| second combining portion | 230 |
| first side | 241 |
| second side | 242 |
| third side | 243 |
| first protrusion | 251 |
| second protrusion | 252, 252' |
| end surface of the second protrusion | 252a, 252b |
| third protrusion | 253 |
| fourth protrusion | 254 |
| bottom surface of the sectional material pressing member | 255 |
| first groove | 261 |
| second groove | 262 |
| third groove | 263 |
| elastic strip | 270 |
| photovoltaic module | 300 |
| bracket | 400 |

Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present.

The embodiments of the present application describe a sectional material pressing member and a sectional material. The sectional material pressing member is used for combining and fixing a sectional material with a side groove in a side surface. One side of the sectional material pressing member is provided with a first combining portion used for combining a side groove of one sectional material, an opposite other side of the sectional material pressing member is provided with a second combining portion for combining a side groove of another sectional material. The sectional material pressing member has a penetrating fastening hole. When the sectional material pressing member is installed on a bracket of the photovoltaic module, the sectional material pressing member can be fixed by passing a fastener through the fastening hole.

An upper end of a mouth of the side groove of the sectional material has a first convex strip. The first combining portion and the second combining portion of the sectional material pressing member respectively include a first side as well as a second side and a third side respectively connecting two ends of the first side. There's a first protrusion between the first side and the second side. When the sectional material pressing member is combined with the sectional material, the first protrusion crosses the first convex strip and snaps into a top surface of the side groove. Therefore, the sectional material pressing member and the sectional material can be easily assembled. In addition, the first convex strip can prevent the first protrusion from being detached from the side groove.

Embodiments of the present application will be further described below with reference to the accompanying drawings.

First embodiment

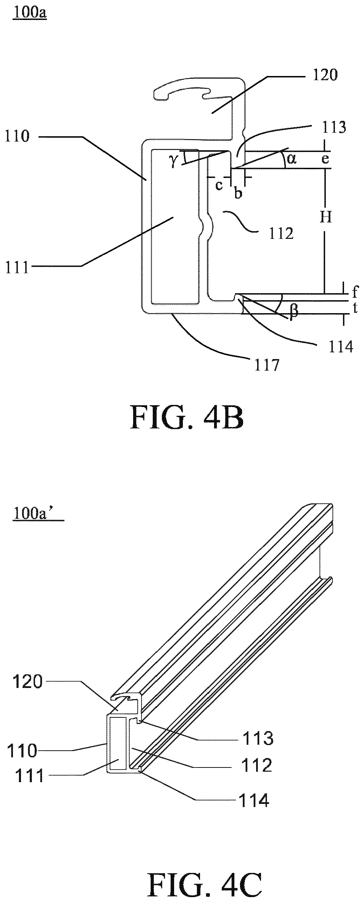

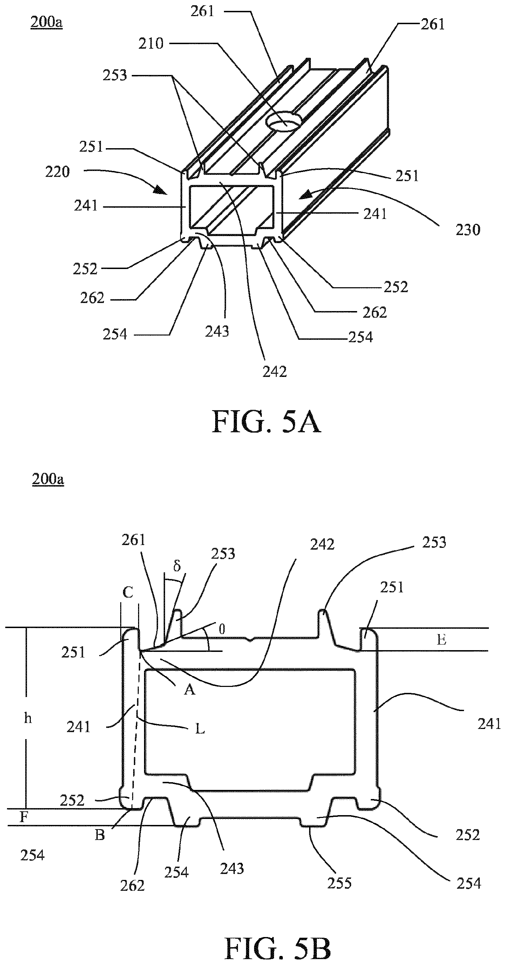

FIG. 4A is a schematic three-dimensional structural diagram of a sectional material used for photovoltaic module frames according to the first embodiment of the present application; FIG. 4B is a schematic cross-sectional view of a sectional material used for a photovoltaic module frame according to the first embodiment of the present application; FIG. 5A is a schematic three-dimensional structural diagram of a sectional material pressing member according to the first embodiment of the present application; FIG. 5B is a schematic cross-sectional view of a sectional material pressing member according to the first embodiment of the present application. With reference to FIGS. 4A-5B, one embodiment of the present invention provides a sectional material pressing member 200a, used for combining and fixing sectional materials 100a. The sectional material 100a comprises an outer frame 110 and a bearing part 120, and the outer frame 110 has a cavity 111, a side surface of the outer frame 110 has a side groove 112 for installing a sectional material pressing member, the bearing part 120 is located on the outer frame 110 and is used to carry a workpiece to be installed. In some embodiments of the present application, the workpiece to be installed is a photovoltaic module. The sectional material pressing member 200a has a first combining portion 220 on one side for combining the side groove 112 of a sectional material 100a, an opposite other side of the sectional material pressing member 200a has a second combining portion 230 for combining the side groove 112 which has a same shape of another sectional material 100a, and the sectional material pressing member 200a has a penetrating fastening hole 210. Specifically, in this embodiment, the fastening hole 210 is located in the middle of the sectional material pressing member 200a.

Further, as shown in FIGS. 4A-5B, in some embodiments of the present invention, the upper and lower ends of the side groove 112 have a first convex strip 113 and a second convex strip 114 respectively. In this embodiment, the side groove 112 is located on the right side of the sectional material 100a, and the first convex strip 113 and the second convex strip 114 face each other up and down. The first combining portion 220 and the second combining portion 230 respectively include a first side 241, and a second side 242 and a third side 243 respectively connecting two ends of the first side 241. Here, the second side and the third side of the first combining portion 220 and the second combining portion 230 extend as one. A first protrusion 251 is provided between the first side 241 and the second side 242, and a second protrusion 252 is provided between the first side 241 and the third side 243. When the sectional material pressing member 200a is combined with the sectional material 100a, the first protrusion 251 crosses the first convex strip 113 and snaps into the top surface of the side groove 112, and the second protrusion 252 crosses the second convex strip 114 and snaps into the bottom surface of the side groove 112. As shown in FIGS. 4A-5B, in this embodiment, the sectional material pressing member 200a is axially symmetrical. In FIGS. 5A-5B, the first combining portion 220 is the left part of the sectional material pressing member 200a, and the second combining portion 230 is the right part of the sectional material pressing member 200a. In the figure, the left side of the sectional material pressing member 200a is the first side 241 of the first combining portion 220; the right side of the sectional material pressing member 200a is the first side 241 of the second combining portion 230; the left and right sides of the upper side of the sectional material pressing member 200a are respectively the second sides 242 of the first combining portion 220 and the second combining portion 230; the left and right sides of the lower side of the sectional material pressing member 200a are respectively the third sides 243 of the first combining portion 220 and the second combining portion 230. In addition, the sectional material pressing member 200a has a first protrusion 251 in the upper left corner and an upper right corner respectively, and has a second protrusion 252 in the lower left corner and lower right corner respectively.

In one embodiment, the lower end of the mouth of the side groove is aligned vertically with the upper end of the mouth. It can be understood that this alignment is approximate, and a small amount of misalignment is allowed. For example, the lower end of the mouth is allowed to retreat into the groove or extend toward the groove relative to the upper end of the mouth.

In the embodiment of the present application, through the special design of the sectional material and the sectional material pressing member, the sectional material pressing member can be snapped into the side groove of the sectional material from the side as long as it is tilted at a smaller angle, such as 10-20°, relative to the bottom surface 117 of the sectional material. Specifically, the end surface of the first convex strip 113 of the sectional material pressing member 100a is inclined upwards in the direction from inside to outside. Assume that the inclination angle of the end surface of the first convex strip 113 relative to the bottom surface 117 (it lies on the horizontal plane when the sectional material is placed horizontally) of the sectional material is $\alpha$, which satisfies the following conditions:

$$\alpha = argtan(\frac{b + c}{H + e})$$

Here, $b$ is the thickness of the first convex strip 113, $e$ is the height of the first convex strip 113, c is the depth of the side groove, and H is the width of the mouth of the side groove (the distance between the surface of the lower end of the first convex strip 113 and the surface of the upper end of the second convex strip 114).

The end surface of the second convex strip 114 of the side groove is inclined downwards in the direction from the inside to the outside, and assume the inclination angle of the second convex strip 114 of the side groove relative to the bottom surface 117 of the sectional material is $\beta$.

The top surface of the side groove is inclined upwards in the direction from the inside to the outside, and assume the inclination angle relative to the bottom surface 117 of the sectional material is $\gamma$, $\gamma \geq \alpha$.

When $\alpha$ and $\gamma$ meet the aforementioned conditions, the sectional material pressing member can be tilted at a smaller angle relative to the bottom surface 117 of the sectional material and screwed into the side groove of the sectional material.

In some embodiments, the angle range of $\alpha$, $\beta$ and $\gamma$ is 10-20°, optionally 15-18°.

In addition, the height of the first convex strip 113 should not be too high, so that the sectional material pressing member 200a is tilted at a smaller angle relative to the sectional material and screwed into the side groove of the sectional material. Moreover, the height of the first convex strip 113 should not be too low, otherwise the sectional material pressing member 200a will easily detach from the side groove. For example, the height $e$ of the first convex strip 113 is 2.5-3.5 mm. The height of the second convex strip 114 should not be too high, so that the sectional material pressing member 200a can be screwed into the side groove of the sectional material. Moreover, the height of the second convex strip 114 should not be too low, otherwise the sectional material pressing member 200a will easily detach from the side groove. For example, the height $f$ of the second convex strip 114 is 0.8-1.5 mm. Correspondingly, in the sectional material pressing member 200a, the distance $h$ between the end surface of the first protrusion 251 and the end surface of the second protrusion 252 is larger than the distance $H$ between the end surface of the first convex strip 113 of the side groove 112 and the lower wall surface of the side groove, and smaller than $H+e$, usually only slightly smaller. The second side 242 of the sectional material press member 200a is inclined upwards in the direction from the outside to the inside, and an inclination angle relative to the bottom surface 255 (when the sectional material pressing member 200a is laid flat, the bottom surface 255 of the sectional material is in a horizontal state) of the sectional material press member is $\theta$. The third protrusion 253 has an inclined surface facing the first protrusion 251, and the inclination angle of the inclined surface relative to the first side 241 (when the sectional material pressing member 200a is laid flat, the first side 241 is in a vertical state) is $\delta$. Here, $\theta \geq \alpha$, and $\delta \geq \alpha$ are satisfied, so that when the sectional material pressing member 200a is screwed into the side groove, it will not be hindered by the top surface of the side groove or the first convex strip.

It can be understood that when sectional materials and sectional material pressing members are matched, the space to accommodate a certain part should be slightly larger than that certain part. For example, the depth $c$ of the side groove 112 is slightly larger than the thickness $C$ (left-right direction in the figure) of the first protrusion 251, the projected thickness of the first groove 261 in the horizontal direction is slightly larger than the thickness of the first convex strip 113, the depth $c$ of the side groove 112 is also slightly larger than the thickness(left and right directions in the figure) of the second protrusion 252, the projected thickness of the second groove 262 in the horizontal direction is slightly larger than the thickness of the second convex strip 114, and the height $E$ of the first protrusion 251 is slightly larger than the height $e$ of the first convex strip 113 and so on. Assuming the vertical distance between the bottom surface of the second protrusion 252 and the bottom surface of the sectional material pressing member is $F$, then $F$ is less than or equal to the vertical distance $t$ between the bottom surface of the side groove 112 and the bottom surface of the sectional material. In this way, after the sectional material and the sectional material pressing member are assembled, the second protrusion 252 can be pressed against the bottom surface of the side groove 113.

In addition, the distance $L$ between the outer endpoint A of the first groove 261 and the lower end B of the second protrusion 252 is less than or equal to the width $H$ of the mouth of the side groove, so that the sectional material pressing member 200a can be stuck into the side groove. Since the sectional material pressing member 200a in this embodiment has a symmetrical structure, the first grooves 261 on both sides meet this condition and fit with sectional materials with the same structure and parameters.

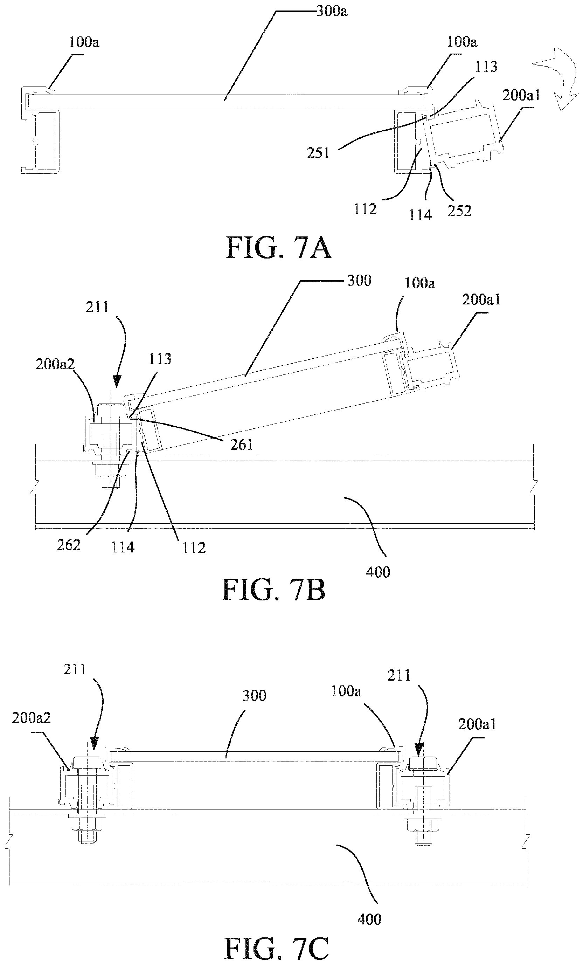

Through the above design, the sectional material pressing member 200a can be slightly inclined (refer to FIG. 7A), and the first protrusion 251 can cross the first convex strip 113 and be inserted into the side groove 112, at this time, the second side 242 cooperates with the end surface of the first convex strip 113, while the sectional material pressing member 200a rotates in a direction such that the bottom surface 255 of the sectional material pressing member 200a is parallel to the bottom surface 117 of the sectional material 100a, the second protrusion 252 passes over the second convex strip 114 and enters the side groove 112. Since the aforementioned $h$ is greater than $H$, it is not easy for the sectional material pressing member 200a to slide out of the side groove 112.

When the sectional material pressing member 200a is jointed with the sectional material 100a, the gap between the side surface of the sectional material pressing member 200a (more specifically, the second side 242) and the side surface of the side groove 112 of the sectional material 100a is less than or equal to 2 mm. In one embodiment, a lateral protrusion 116 can be provided on the side of the side groove 112, which can limit the gap between the side of the side groove 112 and the second side 242 of the sectional material pressing member 200a.

It should be emphasized that the above-mentioned "left and right sides" are merely directional concepts for ease of understanding, and do not mean that the left/right sides of the sectional material pressing member 200a are actually two separate parts.

Furthermore, in this embodiment, the second side 242 has a third protrusion 253 spaced opposite to the first protrusion 251, the third side 243 has a fourth protrusion 254 spaced opposite to the second protrusion 252, and a first groove 261 is formed between the first protrusion 251 and the third protrusion 253 to fit with the first convex strip 113, a second groove 262 is formed between the second protrusion 252 and the fourth protrusion 254 to fit with the second convex strip114, such as through snapping. Similarly, in this embodiment, the left and right sides of the upper side of the sectional material pressing member 200a are respectively provided with a third protrusion 253; the left and right sides of the lower side of the sectional material pressing member 200a are respectively provided with a fourth protrusion 254. Furthermore, in this embodiment, there are two symmetrical first grooves 261 and two second grooves 262 on the sectional material pressing member 200a. It is worth noting that when there are fourth protrusions 254, the bottom surface 255 of the sectional material pressing member is the end surface of two fourth protrusions 254 (as shown in FIG. 5B). When there is no fourth protrusion 254, the bottom surface of the sectional material pressing member is the surface between the two fourth protrusions 254 in FIG. 5B.

FIG. 4C is a variation of a sectional material used for the frame of a photovoltaic module according to the first embodiment of the present application. Referring to FIG. 4C, the difference between the sectional material 100a' in this embodiment and that shown in FIG. 4A is that the groove surface of the side groove 112 is flat and there is no lateral protrusion 116 as shown in FIG. 4A.

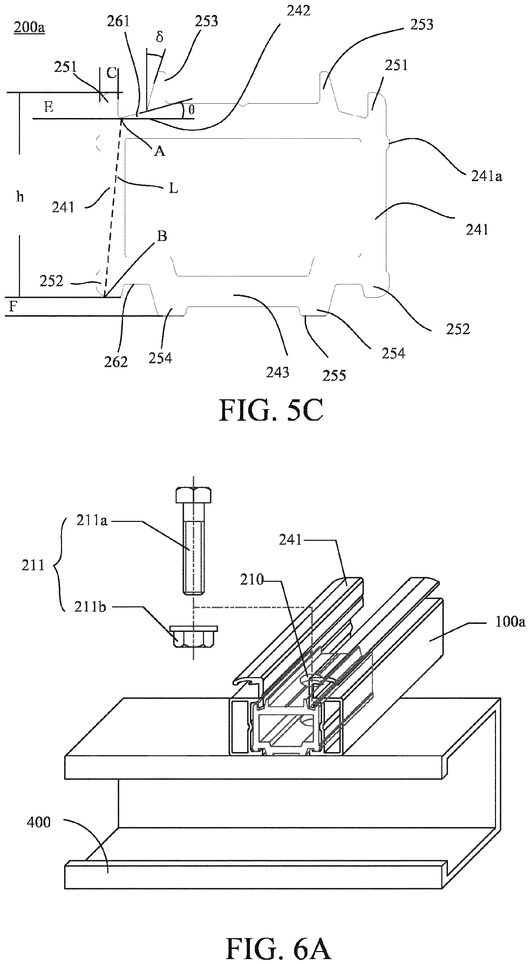

FIG. 5C is a variation of a sectional material pressing member according to the first embodiment of the present application. Referring to FIG. 5C, there is a protrusion 241a on the first side 241 of the sectional material pressing member.

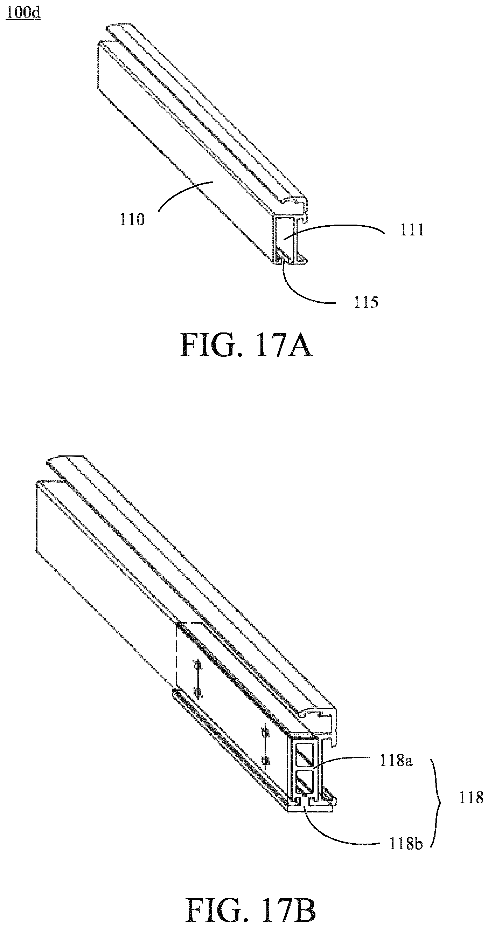

In an embodiment of the present application, one or more positions of the sectional material can also be provided with additional reinforcements as needed. For example, as shown in FIGS. 17A and 17B, the bottom of the outer frame 110 of the sectional material 100c has an opening 115. The sectional material includes a reinforcement 118 inserted into the cavity 111 from the opening 115. The reinforcement 118 may include a support part 118a and a bottom edge 118b. The support part 118a vertically intersects with the bottom edge 118b and is formed integrally. In various embodiments, the support part 118a in the cross-section has a shape resembling the Chinese character for 'king'(with three horizontal strokes and one vertical stroke), a shape resembling the Chinese character for 'sun' (with three horizontal strokes and two vertical strokes, as shown in the figure), a shape resembling the Chinese character for 'eye'(with four horizontal strokes and two vertical strokes) , inverted T, frame, multiple frames, half frame, "O", trapezoid, lower chamfered square, a shape resembling the Chinese character for 'mountain'(with three vertical strokes and one horizontal stroke) , "Z", "2", inverted "m", "u" or "n".

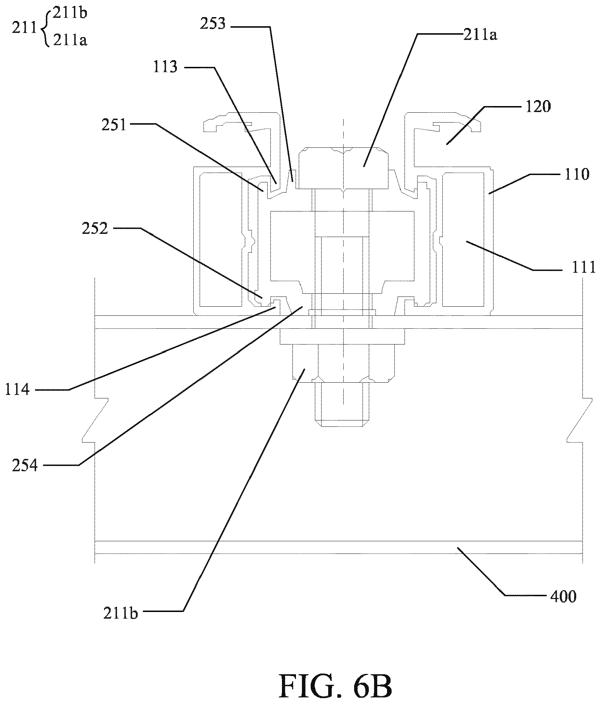

FIG. 6A is a schematic three-dimensional structural diagram of the assembly method of a sectional material and sectional material pressing members according to the first embodiment of the present application; FIG. 6B is a schematic cross-sectional view of the assembly method of a sectional material and sectional material pressing members according to the first embodiment of the present application. With reference to the above content and what is shown in FIGS. 6A-6B, the assembly method of the sectional material 100a and the sectional material pressing member 200a in this embodiment is specifically as follows: two sectional materials 100a are symmetrically fixed on both sides of the sectional material pressing member 200a, and the left and right sides are respectively connected by fixing the first protrusion 251 and the second protrusion 252 into the side groove 112, after the fixation is completed, the first groove 261 (referring to FIG. 5A ) composed of the first protrusion 251 and the third protrusion 253 of the sectional material pressing member 200a fits the first convex strip 113 of the sectional material 100a, the second groove 262 (referring to FIG. 5A ) composed of the second protrusion 252 and the fourth protrusion 254 of the sectional material pressing member 200a fits with the second convex strip 114 of the sectional material 100a. Further, the fastener 211 fixes the sectional material pressing member 200a to the bracket 400 through the fastening hole 210, thereby simultaneously fixing the two sectional materials 100a installed on the left and right sides of the sectional material pressing member 200a. Specifically, in this embodiment, the fastener 211 includes a screw 211a and a screw nut 211b.

FIGS. 7A-7C are schematic diagrams of the assembly steps of a sectional material and sectional material pressing members according to the first embodiment of the present application. As shown with reference to FIGS. 7A-7C, the method for installing the sectional material pressing member 200a and the sectional material 100a described in the above embodiment is:

(1) Install the first combining portion of the first sectional material pressing member in the side groove of the sectional material with the photovoltaic module. As shown in FIG. 7A, four sectional materials 100a (two are shown in the figure) are installed around the photovoltaic module 300a, first install a first sectional material pressing member 200a1 on the side groove of a sectional material 100a on one side (right side shown in FIG. 7A), and rotate the first sectional material pressing member 200a1 at a smaller angle (such as 10-20° or 15-18°) so that it can be snapped into the side groove 112; after that, rotate the first sectional material pressing member 200a1 until the bottom surface of the first sectional material pressing member 200a1 is parallel to the bottom surface of the sectional material.

(2) Snap the side groove of the sectional material with the first sectional material pressing member with a second combining portion of a second sectional material pressing member which is installed on a bracket by a fastener. As shown in FIG. 7B, the second sectional material pressing member 200a2 is fixed on the bracket 400 through the fastener 211, it should be noted that the fastener 211 is not tightened at this time, so that the second sectional material pressing member 200a2 has an amount of up and down movement equal to a height *f* of the second convex strip, so that the sectional material on the other side has a certain space to allow the photovoltaic module to be rotated and snapped in. Align the first convex strip 113 of the side groove 112 of the sectional material 100a on the other side (the left side shown in FIG. 7B) of the photovoltaic module 300 with the first groove 261 of the second sectional material pressing member 200a2 that has been fixed on the bracket 400, rotate the module about 10-20° or 15-18°, so that the second convex strip 114 of the side groove 112 of the left sectional material 10 in the figure is snapped into the second groove 262 of the second sectional material pressing member 200a2. Afterwards, rotate the module until the bottom surface of the sectional material is parallel to the second sectional material pressing member.

(3) Install the first sectional material pressing member on the bracket through the fastener. As shown in FIG. 7C, tighten the fastener 211 installed in step (2) (the left fastener 211 shown in FIG. 7C), and then use another fastener 211 to tighten the first sectional material pressing member 200a1 installed in step (1) on the bracket 400, similarly, the fastener 211 is not tightened at this time, so that the second sectional material pressing member 200a2 has an amount of up and down movement equal to a height f of the second convex strip, so that the sectional material on the other side has a certain space to allow the photovoltaic module to be rotated and snapped in.

When each sectional material pressing member is combined with the sectional material, the gap between the side of the sectional material pressing member (more specifically, the first side 241) and the side of the side groove 112 of the sectional material is less than or equal to 2 mm.

Repeat the above steps (1)-(3) to complete the installation of multiple sectional materials 100a and photovoltaic modules 300.

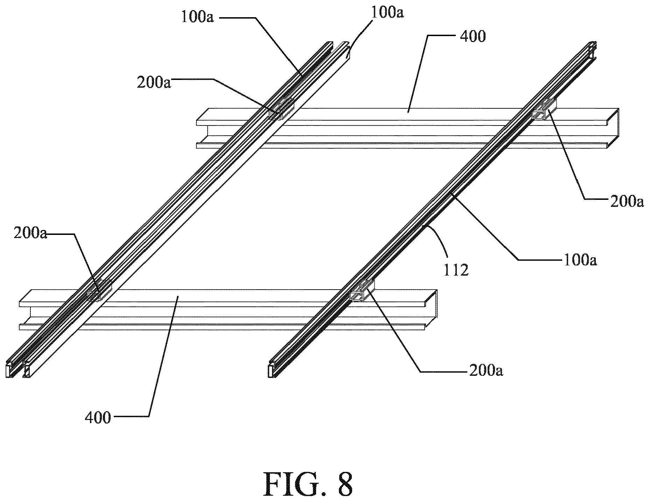

FIG. 8 is a three-dimensional schematic diagram of photovoltaic module installation according to an embodiment of the present application. After going through the steps shown in FIGS. 7A-7C, part of the frame of the photovoltaic module that has been installed (with the photovoltaic module and horizontal sectional materials hidden) is as shown in FIG 8. The photovoltaic module frame includes a plurality of sectional material pressing members 200a as described above; a plurality of strip-shaped sectional materials 100a, each sectional material 100a having a bearing part 120 for carrying the workpiece to be installed (referring to FIG. 4A), the side surfaces of each sectional material 100a has a side groove 112, and at least one sectional material pressing member 200a is installed on the side groove 112.

The plurality of sectional materials 100a surround an enclosed area for carrying a photovoltaic module.

Optionally, at least some of the plurality of sectional materials 100a (the two sectional materials 100a on the left in the figure) are arranged adjacently, and the adjacently arranged sectional materials 100a share the sectional material pressing member 200a.

In one embodiment of the present invention, the length of the sectional material pressing member 200a is shorter than the length of the sectional material 100a to save material.

In one embodiment of the present invention, the sectional material pressing member 200a is not part of the photovoltaic module, but forms the support structure of the photovoltaic module together with the bracket 400. The sectional material 100a on the frame of the photovoltaic module has a side groove, the photovoltaic module and the support structure are installed through the connection between the sectional material's side groove and the sectional material pressing member, therefore, the connection between the photovoltaic module and the support structure is in the form of snap fit.

It should be noted that in the embodiment shown in FIG. 8, there are four sectional material pressing members 200a, which fix three sectional materials 100a, but the number of sectional materials 100a that can be installed during actual operation is not limited to this, and the specific number is not limited in this application.

Second embodiment

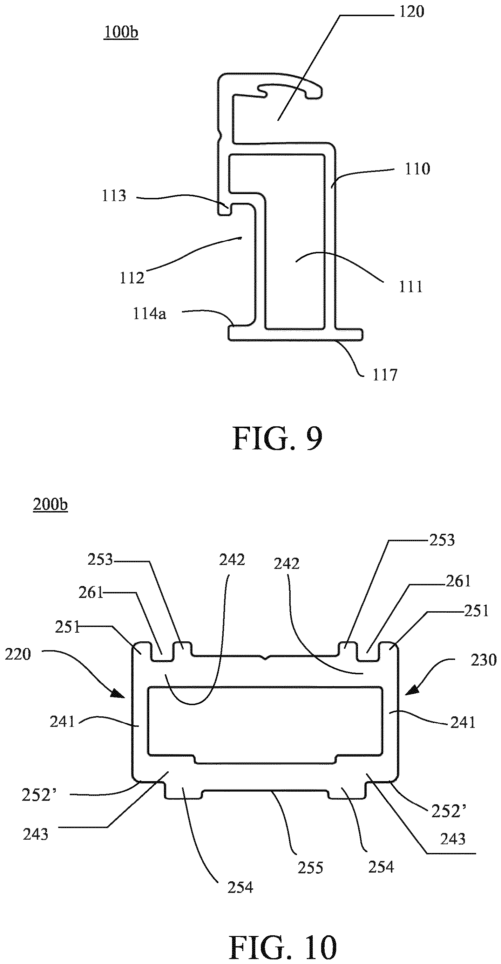

FIG. 9 is a schematic cross-sectional view of a sectional material used for a photovoltaic module frame according to the second embodiment of the present application; FIG. 10 is a schematic cross-sectional view of a sectional material pressing member according to the second embodiment of the present application. Referring to FIGS. 9-10, in one embodiment of the present invention, the upper end of the mouth of the side groove 112 of the sectional material 100b has a first convex strip 113, and the lower end 114a of the mouth of the groove is flat. The first combining portion 220 and the second combining portion 230 of the sectional material pressing member 200b respectively include a first side 241, and a second side 242 and a third side 243 respectively connecting two ends of the first side 241, wherein there's a first protrusion 251 between the first side 241 and the second side 242. The connection point 252' between the first side 241 and the third side 243 has no protrusion and is also flat. When the sectional material pressing member 200b is installed with the sectional material 100b, the first protrusion 251 crosses the first convex strip 113 and snaps into the top surface of the side groove 112, while the third side 243 can directly slide into the side groove 112 and fit with the bottom surface of the side groove 112. Therefore, compared with the first embodiment, the sectional material pressing member in this embodiment is easier to be installed.

As shown in FIGS. 9-10, the side groove 112 is located on the left side of the sectional material 100b. In this embodiment, the sectional material pressing member 200b is axially symmetrical, the first combining portion 220 is the left part of the sectional material pressing member 200b, and the second combining portion 230 is the right part of the sectional material pressing member 200b. In the figure, the left side of the sectional material pressing member 200b is the first side 241 of the first combining portion 220; the right side of the sectional material pressing member 200b is the first side 241 of the second combining portion 230; the left and right sides of the upper side of the sectional material pressing member 200b are respectively the second sides 242 of the first combining portion 220 and the second combining portion 230; the left and right sides of the lower side of the sectional material pressing member 200b are respectively the third sides 243 of the first combining portion 220 and the second combining portion 230. In addition, the upper left corner and the upper right corner of the sectional material pressing member 200b each have a first protrusion 251.

Since there is no second convex strip, the inclination angle of the end surface of the first convex strip 113 relative to the bottom surface 117 of the sectional material 100b is 0, and the inclination angle of the top surface of the side groove 112 relative to the bottom surface 117 of the sectional material 100b is 0. Correspondingly, the inclination angle of the upper surface of the second side 242 inside the first protrusion 251 relative to the bottom surface 255 of the sectional material is 0.

It should be emphasized that the above-mentioned "left and right sides" are merely directional concepts for ease of understanding, and do not mean that the left/right sides of the sectional material pressing member 200b are actually two separate parts.

Furthermore, in this embodiment, the second side 242 of the sectional material pressing member 200b has a third protrusion 253 spaced opposite to the first protrusion 251, and a first groove 261 is formed between the first protrusion 251 and the third protrusion 253 to fit with the first convex strip 113, such as through snapping. At this time, a part of the upper surface of the second side 242 serves as the bottom surface of the groove. In addition, the third side 243 has a fourth protrusion 254 adjacent to the connection point 252'. When the sectional material pressing member 200b is combined with the sectional material 100b, the end surface of the fourth protrusion 254 is flush with the bottom surface of the sectional material 100b.

Other details in this embodiment that are similar to those in the first implementation will not be described again.

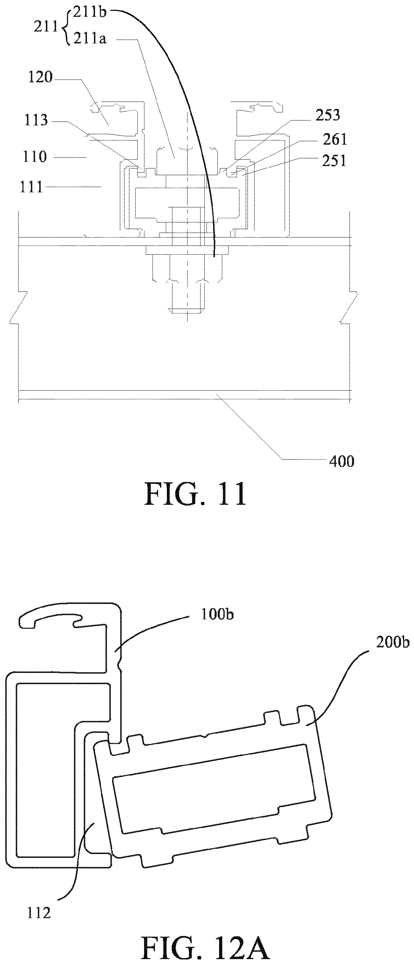

FIG. 11 is a schematic cross-sectional view of the assembly method of a sectional material and sectional material pressing members according to the second embodiment of the present application. With reference to the above content of this embodiment and what is shown in FIG. 11, the assembly method of the sectional material 100b and the sectional material pressing member 200b in this embodiment is specifically as follows: two sectional materials 100b are symmetrically fixed on both sides of the sectional material pressing member 200b, and the left and right sides are respectively connected by fixing the first protrusion 251 into the side groove 112, after the fixation is completed, the first groove 261 composed of the first protrusion 251 and the third protrusion 253 of the sectional material pressing member 200b fits the first convex strip 113 of the sectional material 100b. Further, the fastener 211 fix the sectional material pressing member 200b to the bracket 400 through the fastening hole 210, thereby simultaneously fixing the two sectional materials 100b installed on the left and right sides of the sectional material pressing member 200b. Specifically, in this embodiment, the fastener 211 includes a screw 211a and a screw nut 211b.

FIGS. 12A-12B are schematic diagrams of the assembly steps of a sectional material and sectional material pressing members according to the second embodiment of the present application. As shown with reference to FIGS. 12A-12C, the method for installing the sectional material pressing member 200a and the sectional material 100a described in this embodiment is:

(1) As shown in FIG. 12A, first install the sectional material pressing member 200b on a side of the first sectional material 100b on the photovoltaic module frame (with photovoltaic modules), rotate the first combining portion of the sectional material pressing member 200b by a smaller predetermined angle (such as tilting 10-20° or 15-18°) relative to the first sectional material 100b to snap into the side groove 112 of the sectional material 100b, and then rotate the sectional material pressing member 200b until the bottom surface of the sectional material pressing member 200b is parallel to the bottom surface of the first sectional material 100b;

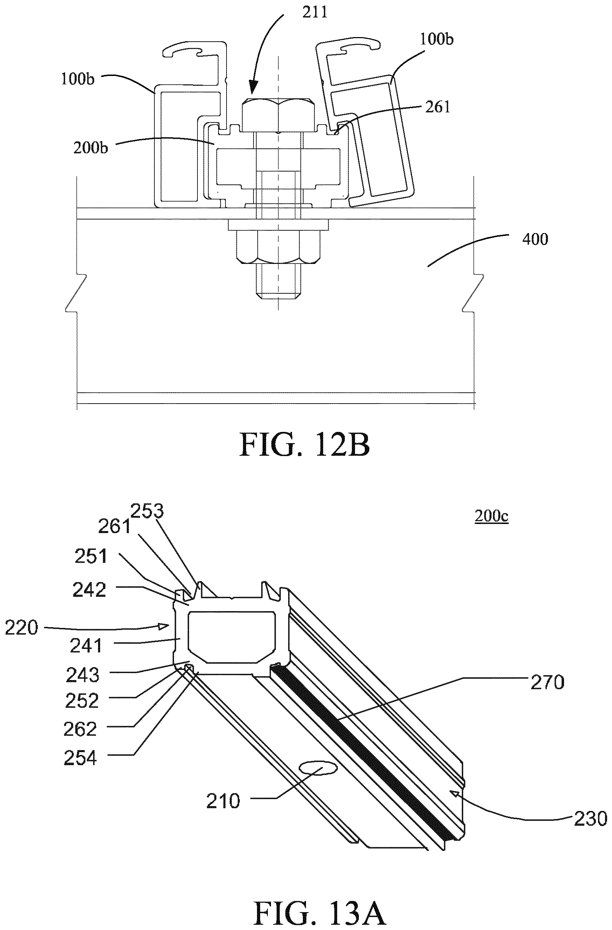

(2) As shown in FIG. 12B, fix the sectional material pressing member 200b installed in step (1) on the bracket 400 through the fasteners 211, and tighten the fasteners 211. Install the second sectional material 100b on the frame of another photovoltaic module on the other side of the sectional material pressing member 200b (right side shown in FIG. 12B), rotate the sectional material 100b at a small angle (such as 10-20° or 15-18°) to insert the first convex strip 113 into the first groove 261 and make the lower end of the side groove 112 fit with the sectional material pressing member 200b as shown in the figure, the sectional material 100b is engaged with the second combining portion of the sectional material pressing member 200b, and then rotate the sectional material 100b until the bottom surface of the sectional material 100b is parallel to the bottom surface of the sectional material pressing member 200b.

When each sectional material pressing member is combined with the sectional material, the gap between the side of the sectional material pressing member (more specifically, the second side 242) and the side surface of the side groove 112 of the sectional material is less than or equal to 2 mm.

Repeat the above steps (1)-(2) to complete the installation of multiple sectional materials 100b and photovoltaic modules.

In one embodiment of the present invention, the sectional material pressing member 200b is not part of the photovoltaic module, but forms the support structure of the photovoltaic module together with the bracket 400. The sectional material 100b on the frame of the photovoltaic module has a side groove, the photovoltaic module and the support structure are installed through the connection between the sectional material's side groove and the sectional material pressing member, therefore, the connection between the photovoltaic module and the support structure is in the form of snap fit.

Third embodiment

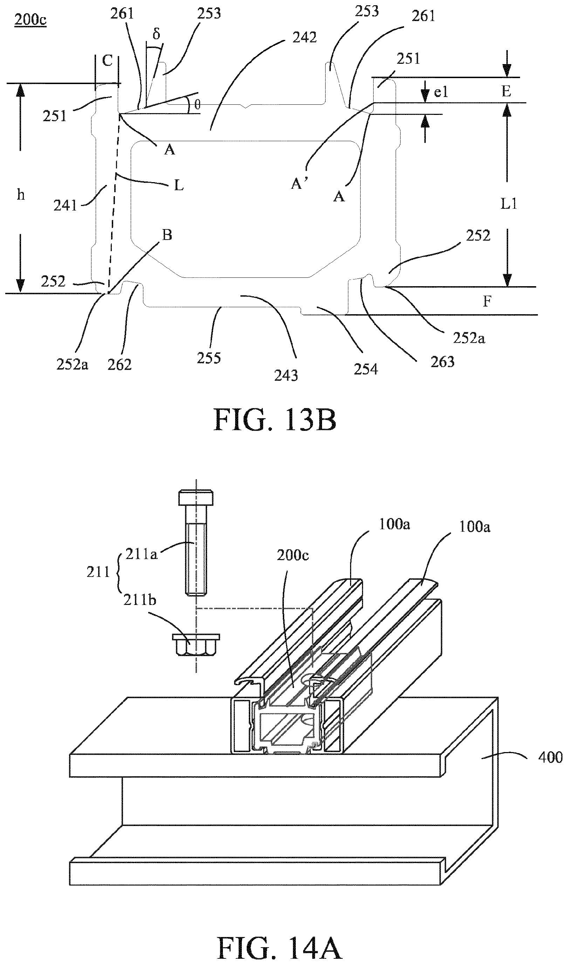

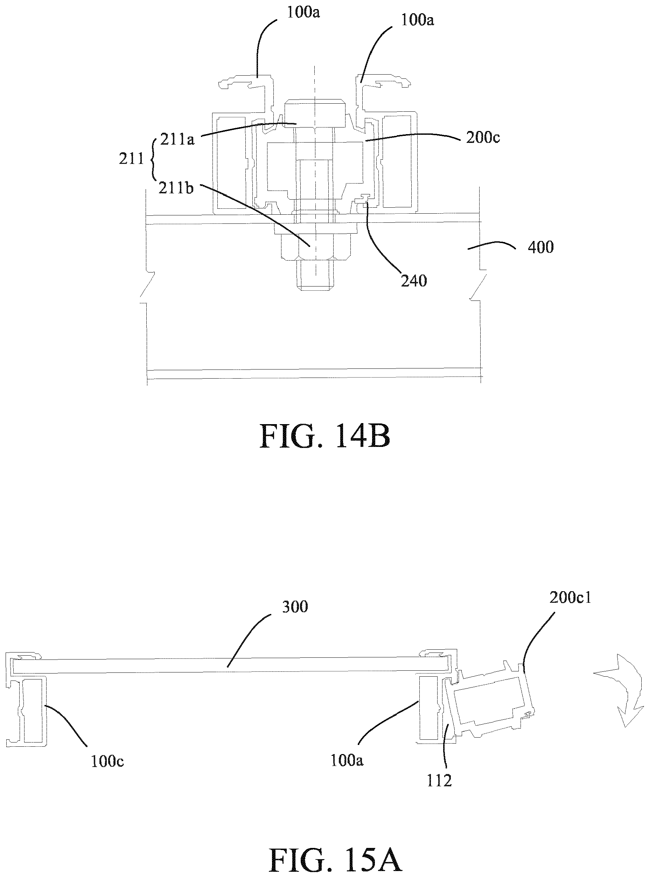

FIG. 13A is a schematic three-dimensional structural diagram of a sectional material pressing member with an elastic strip according to the third embodiment of the present application; FIG. 13B is a schematic cross-sectional view of a sectional material pressing member with an elastic strip according to the third embodiment of the present application. As shown with reference to FIGS. 4A-4B and 13A-13B, in one embodiment of the present invention, the upper and lower ends of the side groove 112 of the sectional material 100a have a first convex strip 113 and a second convex strip 114 respectively, the first combining portion 220 and the second combining portion 230 respectively include a first side 241, and a second side 242 and a third side 243 respectively connecting two ends of the first side 241, wherein a first protrusion 251 is provided between the first side 241 and the second side 242, and a second protrusion 252 is provided between the first side 241 and the third side 243. In addition, the height of the end surface 252b of the second protrusion 252 of the second combining portion 230 relative to the bottom surface 255 of the sectional material pressing member is higher than the height of the end surface 252a of the second protrusion 252 of the first combining portion 220 relative to the bottom surface 255 of the sectional material press. When the sectional material pressing member 200b is combined with the two sectional materials 100a, the first protrusions 251 of the first combining portion 220 and the second combining portion 230 cross the first convex strips 113 and snap into the top surfaces of the side grooves 112, the second protrusion 252 of the first combining portion 220 crosses the second convex strip 114 and snaps into the bottom surface of the side groove 112, the second protrusion 252 of the second combining portion crosses the second convex strip 114 and faces the bottom surface of the side groove 112 (refer to FIG. 14B).

In addition, an elastic strip 270 is provided in the third groove 263 of the second combining portion 230 (the elastic strip is not shown in FIG. 13B). When the second combining portion of the sectional material pressing member 200b is coupled to the sectional material 100a, the elastic strip 270 of the second combining portion 230 contacts the second convex strip 114. In the embodiment of the present application, the elastic strip 270 is a rubber strip or a spring clip.

As shown in FIGS. 13A-13B, in this embodiment, the first combining portion 220 is the left part of the sectional material pressing member 200c, and the second combining portion 230 is the right part of the sectional material pressing member 200c. In the figure, the left side of the sectional material pressing member 200c is the first side 241 of the first combining portion 220; the right side of the sectional material pressing member 200c is the first side 241 of the second combining portion 230; the left and right sides of the upper side of the sectional material pressing member 200c are respectively the second sides 242 of the first combining portion 220 and the second combining portion 230; The left and right sides of the lower side of the sectional material pressing member 200c are the third sides 243 of the first combining portion 220 and the second combining portion 230 respectively. In addition, the sectional material pressing member 200c has a first protrusion 251 in the upper left corner and an upper right corner respectively, a second protrusion 252 in the lower left corner, and another second protrusion 252 in the lower right corner. The height of the end surface 252b of the second protrusion 252 of the second combining portion 230 relative to the bottom surface 255 of the sectional material pressing member is higher than the height of the end surface 252a of the second protrusion 252 of the first combining portion 220 relative to the bottom surface 255 of the sectional material pressing member, and this makes it easier for the second combining portion 230 to be jointed with the side groove of the sectional material while still maintaining the fixation after jointing.

For various size settings of the first combining portion 220, reference may be made to the first embodiment. For example, the distance L between the outer endpoint A of the first groove 261 of the first combining portion and the lower point of the second protrusion B of the first combining portion is less than or equal to the width $H$ of the mouth of the side groove. The dimensions of the second combining portion 230 are different. In particular, the vertical distance $L1$ between the floating outer endpoint A' of the first groove 261 of the second combining portion 230 and the end surface 252a of the second protrusion 252 of the second combining portion 230 is less than or equal to the width H of the mouth of the side groove. Here the floating outer endpoint A' is the lowest point where the first groove 261 contacts the lower endpoint of the first convex strip of the sectional material 100a when the sectional material pressing member 200c is combined with the sectional material 100a, and the floating outer endpoint A' is higher than the outer endpoint A. For example, the height difference $e1$ between the floating outer endpoint A' and the outer endpoint A is equal to the height $f$ of the second convex strip 114. Moreover, the vertical distance $F$ from the end surface 252a of the second protrusion of the second combining portion 230 to the bottom surface of the sectional material pressing member 200b is greater than or equal to the vertical distance $(f+t)$ between the end surface of the notch of the side groove and the bottom surface of the sectional material (refer to the FIG. 4B). Through these designs, the sectional material pressing member 200c can be snapped into the side groove of the sectional material.

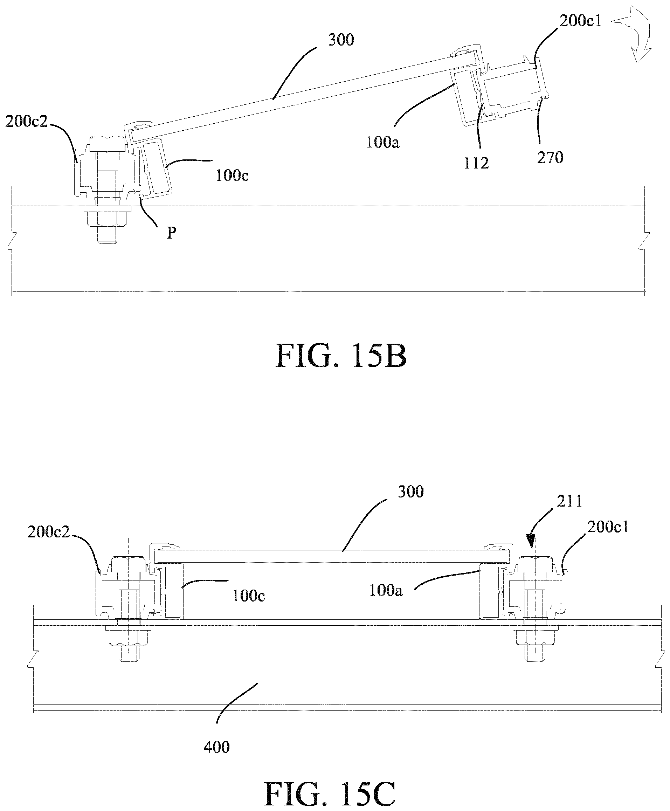

It is worth mentioning that the relationship between *L1* and *H* is designed so that after the sectional material pressing member 200b is installed in place by the fastener, another sectional material can still be combined with the sectional material pressing member 200b (it will be described later with reference to FIGS. 15A-15C).In some embodiments, a chamfer can be designed at the position P where the lower left corner of the sectional material 100a (refer to FIG. 15C) contacts the bracket to reduce the height of the passive elevation of the sectional material 100a when installed, thereby reducing the height of the floating outer endpoint A'. Of course, if the fastener 211 are not tightened during installation as in the first embodiment, so that the sectional material pressing member has an amount of up and down movement equal to a height *f* of the second convex strip, then the second combining portion 230 only needs to satisfy the requirements of *L* and *H.*

Other details in this embodiment that are similar to those in the first embodiment will not be described again.

It should be emphasized that the above-mentioned "left and right sides" are merely directional concepts for ease of understanding, and do not mean that the left/right sides of the sectional material pressing member 200c are actually two separate parts. In addition, the elastic strip in this embodiment serves to provide friction, and its material is, for example, rubber, but this application is not specifically limited here.

Furthermore, in this embodiment, the second side 242 has a third protrusion 253 spaced opposite to the first protrusion 251, the third side 243 of the second combining portion has a fourth protrusion 254 spaced opposite to the second protrusion 252. A first groove 261 is formed between the first protrusion 251 and the third protrusion 253 to fit with the first convex strip 113. A second groove 262 is formed between the second protrusion 252 and the fourth protrusion 254 of the first combining portion to fit(such as snapping) with the second convex strip 114, a third groove 263 is formed between the second protrusion 252 and the fourth protrusion 254 of the second combining portion to fit (such as snapping) with the second convex strip 114.

FIG. 14A is a schematic three-dimensional structural diagram of the assembly method of a sectional material and a sectional material pressing member with an elastic strip according to the third embodiment of the present application; FIG. 14B is a schematic cross-sectional view of the assembly method of a sectional material and a sectional material pressing member with an elastic strip according to the third embodiment of the present application. With reference to FIGS. 13A-14B, the assembly method of the sectional material 100a and the sectional material pressing member 200c in this embodiment is specifically as follows: two sectional materials 100a are respectively fixed on both sides of the sectional material pressing member 200c, the left side is connected by snapping the first protrusion 251 and the second protrusion 252 into the side groove 112, and the right side is connected by snapping the first protrusion 251 into the side groove 112 and make the second convex strip 114 of the side groove 112 contact with the elastic strip 270 at the same time. After the fixation is completed, the first groove 261 composed of the first protrusion 251 and the third protrusion 253 of the sectional material pressing member 200c fits the first convex strip 113 of the sectional material 100a, and the second groove 262 composed of the second protrusion 252 and the fourth protrusion 254 of the first combining portion 220 of the sectional material pressing member 200c fits the second convex strip 114 of the sectional material 100a, the elastic strip 270 of the second combining portion 230 of the sectional material pressing member 200c is in contact with the second convex strip 114 of the sectional material 100a. Further, the fastener 211 fixes the sectional material pressing member 200c to the bracket 400 through the fastening hole 210, thereby simultaneously fixing the two sectional materials 100a installed on the left and right sides of the sectional material pressing member 200c. Specifically, in this embodiment, the fastener 211 includes a screw 211a and a screw nut 211b.

FIGS. 15A-15C are schematic diagrams of the assembly steps of a sectional material and a sectional material pressing member with an elastic strip according to the third embodiment of the present application. As shown with reference to FIGS. 15A-15C, the method for installing the sectional material pressing member 200c and the sectional material 100c described in the above embodiment is:

(1) Install the first combining portion of the first sectional material pressing member in the side groove of the sectional material with the photovoltaic module. As shown in FIG. 15A, two sectional materials 100a are symmetrically installed on the left and right sides of the photovoltaic module 300, first install a first sectional material pressing member 200c1 on the side groove of a sectional material 100a on one side(right side shown in FIG. 7A), and rotate the first sectional material pressing member 200c1 at a smaller angle (such as 10-20° or 15-18°) so that it can be snapped into the side groove 112; after that, rotate the first sectional material pressing member 200c1 until the bottom surface of the first sectional material pressing member 200c1 is parallel to the bottom surface of the sectional material100a.

(2) Snap the side groove of the sectional material with the first sectional material pressing member with a second combining portion of a second sectional material pressing member which is installed on a bracket by a fastener. As shown in FIG. 15B, the second sectional material pressing member 200c2 is fixed on the bracket 400 through the fastener 211, and the fastener 211 is fastened. Align the first convex strip 113 of the side groove 112 of the sectional material 100a on the other side(the left side shown in FIG. 15B) of the photovoltaic module 300 with the first groove 261 of the second sectional material pressing member 200c2 that has been fixed on the bracket 400, rotate the module about 10-20° or 15-18°, so that the second convex strip 114 of the side groove 112 of the left sectional material 100c in the figure is in contact with the elastic strip 270 of the second sectional material pressing member 200c2. Afterwards, rotate the module 300 until the bottom surface of the sectional material 100c is parallel to the second sectional material pressing member 200c2.

(3) Install the first sectional material pressing member on the bracket through the fastener. As shown in FIG. 15C, fix the sectional material pressing member 200c1 installed in step (1) on the bracket 400 through the fastener 211, and tighten the fastener 211.

When each sectional material pressing member is combined with the sectional material, the gap between the side of the sectional material pressing member (more specifically, the first side 241) and the side of the side groove 112 of the sectional material is less than or equal to 2 mm.

Repeat the above steps (1)-(3) to complete the installation of multiple sectional materials and photovoltaic modules 300.

In one embodiment of the present invention, the sectional material pressing members 200c1 and 200c2 are not part of the photovoltaic module, but form the support structure of the photovoltaic module together with the bracket 400. The sectional material 100a on the frame of the photovoltaic module has side grooves, the photovoltaic module and the support structure are installed through the connection between the sectional material's side groove and the sectional material pressing member, therefore, the connection between the photovoltaic module and the support structure is in the form of snap fit.

Forth embodiment

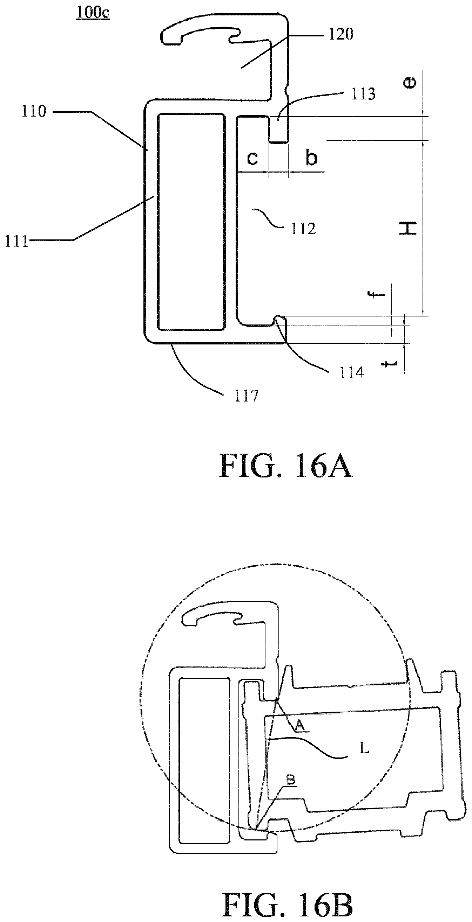

FIG. 16A is a schematic structural diagram of a sectional material according to the fourth embodiment of the present application. FIG. 16B is a schematic assembly diagram of a sectional material and a sectional material pressing member according to the fourth embodiment of the present application. As shown with reference to FIGS. 16A-16B, in an embodiment of the present invention, the end surface of the first convex strip 113 of the side groove 112 of the sectional material 100c is horizontal, that is, the aforementioned $\alpha$=0. Correspondingly, the top surface of the side groove 112 is horizontal, that is, $\gamma$=0.

Under this design, the design of size parameters is simpler. The sectional material pressing member used in this embodiment is similar to FIG. 5B of the first embodiment. When the sectional material 100c and the sectional material pressing member 200a are matched, the space to accommodate a certain part should be slightly larger than that certain part. For example, as shown in FIG. 16A and FIG. 5B, the depth c of the side groove 112 is slightly larger than the thickness $C$(in the left-right direction in the figure) of the first protrusion 251, the projected thickness of the first groove 261 in the horizontal direction is slightly larger than the thickness b of the first convex strip 113, the depth c of the side groove 112 is also slightly larger than the thickness(in the left and right direction in the figure) of the second protrusion 252, the projected thickness of the second groove 262 in the horizontal direction is slightly larger than the thickness of the second convex strip 114, the height $E$ of the first protrusion 251 is slightly larger than the height e of the first convex strip 113 and so on. Assuming the vertical distance between the end surface of the second protrusion 252 and the bottom surface 255 of the sectional material pressing member 200a is $F$, then $F$ is less than or equal to the vertical distance $t$ between the bottom surface of the side groove 112 and the bottom surface 177 of the sectional material. In this way, after the sectional material 100c and the sectional material pressing member 200a are assembled, the second protrusion 252 can be pressed against the bottom surface of the side groove 112.

In addition, the distance $L$ between the outer endpoint A of the first groove 261 and the lower end B of the second protrusion 252 is less than or equal to the width $H$ of the mouth of the side groove, so that the sectional material pressing member 200a can be stuck into the side groove. Since the sectional material pressing member 200a in this embodiment has a symmetrical structure, the first grooves 261 on both sides meet this condition and fit with sectional materials with the same structure and parameters.

Other details in this embodiment that are similar to those in the first embodiment will not be described again.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A sectional material pressing member used for combining and fixing a sectional material with a side groove in a side surface, **characterized in that** one side of the sectional material pressing member is provided with a first combining portion used for combining a side groove of one sectional material, an opposite other side of the sectional material pressing member is provided with a second combining portion for combining a side groove of another sectional material, and the sectional material pressing member comprises a penetrating fastening hole.

2. The sectional material pressing member according to claim 1, **characterized in that** an upper end of a mouth of the side groove comprises a first convex strip, the first combining portion and the second combining portion respectively include a first side, and a second side and a third side respectively connecting two ends of the first side, wherein a first protrusion is provided between the first side and the second side, and the first protrusion is adapted to snap into a top surface of the side groove when the sectional material pressing member is combined with the sectional material.

3. The sectional material pressing member according to claim 2, **characterized in that** a lower end of the mouth of the side groove comprises a second convex strip, and a second protrusion is provided between the first side and the third side, when the sectional material pressing member is combined with the sectional material, the second protrusion snaps into a bottom surface of the side groove.

4. The sectional material pressing member according to claim 3, **characterized in that** the first protrusion crosses the first convex strip and snaps into the top surface of the side groove, and the second protrusion crosses the second convex strip and snaps into the bottom surface of the side groove.

5. The sectional material pressing member according to claim 3, **characterized in that** the second side comprises a third protrusion spaced opposite to the first protrusion, and a first groove is formed between the first protrusion and the third protrusion to fit with the first convex strip.

6. The sectional material pressing member according to claim 3, **characterized in that** the third side comprises a fourth protrusion spaced opposite to the second protrusion, and a second groove is formed between the second protrusion and the fourth protrusion to fit with the second convex strip.

7. The sectional material pressing member according to claim 3, **characterized in that** a height of an end surface of the second protrusion of the second combining portion relative to a bottom surface of the sectional material pressing member is higher than a height of an end surface of the second protrusion of the first combining portion relative to the bottom surface of the sectional material pressing member.

8. The sectional material pressing member according to claim 7, **characterized in that** the second side comprises a third protrusion spaced opposite to the first protrusion, and a first groove is formed between the first protrusion and the third protrusion to fit with the first convex strip.

9. The sectional material pressing member according to claim 7, **characterized in that** a second groove is formed on a position of the third side between the first combining portion and the second protrusion, the third side comprises a fourth protrusion spaced opposite to the second protrusion at the second combining portion, and a third groove is formed between the second protrusion and the fourth protrusion of the second combining portion to fit with the second convex strip.

10. The sectional material pressing member according to claim 9, **characterized by** further comprising an elastic strip formed in the third groove of the second combining portion, when the sectional material pressing member is combined with another sectional material, the elastic strip of the second combining portion contacts the second convex strip.

11. The sectional material pressing member according to claim 2, **characterized in that** a lower end of the mouth of the side groove is flat, wherein a connection point between the first side and the third side is flat, and fits the bottom surface of the mouth of the side groove when the sectional material pressing member is combined with the sectional material.

12. The sectional material pressing member according to claim 11, **characterized in that** the second side comprises a third protrusion spaced opposite to the first protrusion, and a first groove is formed between the first protrusion and the third protrusion to fit with the first convex strip.

13. The sectional material pressing member according to claim 11, **characterized in that** the third side comprises a fourth protrusion adjacent to the connection point, when the sectional material pressing member is combined with the sectional material, an end surface of the fourth protrusion is flush with a bottom surface of the sectional material.

14. The sectional material pressing member according to any one of claims 1-13, **characterized in that** the sectional material pressing member comprises a cavity inside.

15. The sectional material pressing member according to claim 5 or claim 8, **characterized in that** a bottom surface of the first groove is inclined upwards in a direction from outside to inside, and an inclination angle thereof relative to the bottom surface of the sectional material pressing member is greater than or equal to an inclination angle of an end surface of the first convex strip relative to a bottom surface of the sectional material.

16. The sectional material pressing member according to claim 5 or claim 8, **characterized in that** an outer surface of the third protrusion is inclined inwards in a direction from bottom to top, and an inclination angle thereof relative to the first side is greater than or equal to an inclination angle of an end surface of the first protrusion relative to the bottom surface of the sectional material.

17. The sectional material pressing member according to claim 15, **characterized in that** an inclination angle of the bottom surface of the first groove relative to the bottom surface of the sectional material pressing member is between 10-20°.

18. The sectional material pressing member according to claim 16, **characterized in that** an inclination angle of an outer side of the third protrusion relative to the first side is between 10-20°.

19. The sectional material pressing member according to any one of claims 3-4 and 6-10, **characterized in that** a vertical distance between an end surface of the first protrusion and an end surface of the second protrusion end surface is less than the sum of a width of the mouth of the side groove and a height of the first convex strip.

20. The sectional material pressing member according to claim 3 or claim 7, **characterized in that** a vertical distance between an end surface of the second protrusion and the bottom surface of the sectional material pressing member is less than or equal to a vertical distance between the bottom surface of the side groove and a bottom surface of the sectional material.

21. The sectional material pressing member according to claim 7, **characterized in that** a vertical distance between the end surface of the second protrusion of the second combining portion and the bottom surface of the sectional material pressing member is greater than or equal to a vertical distance between an end surface of the mouth of the side groove and a bottom surface of the sectional material.

22. The sectional material pressing member according to claim 5 or claim 8, **characterized in that** a distance between an outer endpoint of the first groove and an end surface of the second protrusion is less than or equal to a width of the mouth of the side groove.

23. The sectional material pressing member according to claim 8, **characterized in that** a vertical distance between a floating outer endpoint of the first groove of the second combining portion and the end surface of the second protrusion of the second combining portion is less than or equal to a width of the mouth of the side groove.

24. The sectional material pressing member according to claim 23, **characterized in that** a height difference between the floating outer endpoint and an outer endpoint of the first groove of the second combining portion is equal to the height of the second convex strip.

25. The sectional material pressing member according to claim 2, **characterized in that** when the sectional material pressing member is combined with the sectional material, a gap between the first side and a side surface of the side groove is less than or equal to 2mm.

26. A sectional material, **characterized by** comprising an outer frame and a bearing part, and the outer frame comprises a cavity, a side surface of the outer frame comprises a side groove for installing a sectional material pressing member, and an upper end of a mouth of the side groove comprises a first convex strip, the bearing part is located on the outer frame and is used to carry a workpiece to be installed.

27. The sectional material according to claim 26, **characterized in that** a bottom of the outer frame comprises an opening, and the sectional material further includes a reinforcement inserted into the cavity from the opening.

28. The sectional material according to claim 26, **characterized in that** an outer surface of a lower end of the mouth of the side groove and an outer surface of the upper end of the mouth are on a same plane.

29. The sectional material according to claim 26, **characterized in that** a lower end of the mouth of the side groove is flat.

30. The sectional material according to claim 26, **characterized in that** a lower end of the mouth of the side groove comprises a second convex strip.

31. The sectional material according to claim 30, **characterized in that** an end surface of the second convex strip is inclined downwards in a direction from inside to outside relative to a bottom surface of the sectional material.

32. The sectional material according to claim 31, **characterized in that** an inclination angle of an end surface of the second convex strip relative to the bottom surface of the sectional material is between 10-20°.

33. The sectional material according to claim 30, **characterized in that** a top surface of the side groove and an end surface of the first convex strip are inclined upwards in a direction from inside to outside, wherein assuming that a thickness of the first convex strip is *b*, a height of the first convex strip is *e*, a depth of the side groove is *c*, a width of the mouth of the side groove is *H*, an inclination angle of the end surface of the first convex strip relative to a bottom surface of the sectional material is $\alpha$, an inclination angle of the top surface of the side groove relative to the bottom surface of the sectional material is $\gamma$, then:

$$\alpha = argtan\left(\frac{b+c}{H+e}\right),$$

$$\gamma \geq \alpha.$$

34. The sectional material according to claim 33, **characterized in that** the inclination angles $\alpha$ and $\gamma$ are between 10-20°.

**35.** The sectional material according to claim 26, **characterized in that** an inclination angle of the top surface of the side groove and the end surface of the first convex strip relative to the bottom surface of the sectional material is 0.

**36.** The sectional material according to claim 30, 33 or 35, **characterized in that** the sectional material pressing member comprises a combining portion combined with the side groove, and the combining portion includes a first side, and a second side and a third side respectively connecting two ends of the first side, a first protrusion is provided at the connection point between the first side and the second side, a second protrusion is provided at the connection point between the first side and the third, when the sectional material is combined with the sectional material pressing member, the first protrusion snaps into the top surface of the side groove, and the second protrusion snaps into the bottom surface of the side groove.

**37.** The sectional material according to claim 36, **characterized in that** a vertical distance between the bottom surface of the side groove and the bottom surface of the sectional material is greater than or equal to a vertical distance between the end surface of the second protrusion's and the bottom surface of the sectional material pressing member.

**38.** The sectional material according to claim 36, **characterized in that** the second side of the sectional material pressing member comprises a third protrusion spaced opposite to the first protrusion, and a first groove is formed between the first protrusion and the third protrusion to cooperate with the first convex strip, wherein a bottom surface of the first groove is inclined upwards in a direction from outside to inside, and an inclination angle thereof relative to the bottom surface of the sectional material pressing member is greater than or equal to an inclination angle of an end surface of the first convex strip relative to a bottom surface of the sectional material.

**39.** The sectional material according to claim 38, **characterized in that** an outer surface of the third protrusion is inclined inwards in a direction from bottom to top, and an inclination angle thereof relative to the first side is greater than or equal to an inclination angle of an end surface of the first protrusion relative to the bottom surface of the sectional material.

**40.** The sectional material according to claim 26, 30 or 33, **characterized in that** a height of the first convex strip is 2.5-3.5mm.

**41.** The sectional material according to claim 30, **characterized in that** a height of the second convex strip is 0.8-1.5mm.

**42.** The sectional material according to claim 36, **characterized in that** the second side comprises a third protrusion spaced opposite to the first protrusion, and a first groove is formed between the first protrusion and the third protrusion to fit with the first convex strip, a width of the mouth of the side groove is greater than or equal to a distance between an outer endpoint of the first groove and the end surface of the second protrusion.

**43.** The sectional material according to claim 36, **characterized in that** when the sectional material pressing member is combined with the sectional material, the gap between the first side and a side surface of the side groove is less than or equal to 2mm.

**44.** The sectional material according to claim 43, **characterized in that** a side surface of the side groove comprises a lateral protrusion.

**45.** A sectional material, **characterized by** comprising an outer frame and a bearing part, wherein the outer frame comprises a cavity, a side surface of the outer frame comprises a side groove for installing a sectional material pressing member, and an upper end of a mouth of the side groove comprises a first convex strip, the bearing part is located on the outer frame and is used to carry a workpiece to be installed, a top surface of the side groove and an end surface of the first convex strip are inclined upwards in a direction from inside to outside, wherein assuming that a thickness of the first convex strip is $b$, a height of the first convex strip is $e$, a depth of the side groove is c, a width of the mouth of the side groove is $H$, an inclination angle of the end surface of the first convex strip relative to a bottom surface of the sectional material is $\alpha$, an inclination angle of the top surface of the side groove relative to the bottom surface of the sectional material is $\gamma$, then:

$$\alpha = argtan\left(\frac{b+c}{H+e}\right),$$

$$\gamma \geq \alpha.$$

46. The sectional material according to claim 45, **characterized in that** a lower end of the mouth of the side groove comprises a second convex strip.

47. The sectional material according to claim 46, **characterized in that** an end surface of the second convex strip is inclined downwards in a direction from inside to outside relative to the bottom surface of the sectional material.

48. The sectional material according to claim 47, **characterized in that** the sectional material pressing member comprises a combining portion combined with the side groove, and the combining portion includes a first side, and a second side and a third side respectively connecting two ends of the first side, a first protrusion is provided at the connection point between the first side and the second side, a second protrusion is provided at the connection point between the first side and the third, when the sectional material is combined with the sectional material pressing member, the first protrusion snaps into the top surface of the side groove, and the second protrusion snaps into a bottom surface of the side groove.

49. The sectional material according to claim 46, **characterized in that** a vertical distance between a bottom surface of the side groove and the bottom surface of the sectional material is greater than or equal to a vertical distance between an end surface of the second protrusion and the bottom surface of the sectional material pressing member.

50. The sectional material according to claim 48, **characterized in that** the second side of the sectional material pressing member comprises a third protrusion spaced opposite to the first protrusion, and a first groove is formed between the first protrusion and the third protrusion to fit with the first convex strip, wherein a bottom surface of the first groove is inclined upwards in a direction from outside to inside, and an inclination angle thereof relative to the bottom surface of the sectional material pressing member is greater than or equal to an inclination angle of an end surface of the first convex strip relative to the bottom surface of the sectional material.

51. The sectional material according to claim 50, **characterized in that** an outer surface of the third protrusion is inclined inwards in a direction from bottom to top, and an inclination angle thereof relative to the first side is greater than or equal to an inclination angle of an end surface of the first protrusion relative to the second side.

52. The sectional material according to claim 46, **characterized in that** a height of the first convex strip is 2.5-3.5mm.

53. The sectional material according to claim 46, **characterized in that** a height of the second convex strip is 0.8-1.5mm.

54. The sectional material according to claim 50, **characterized in that** a width of the mouth of the side groove is greater than or equal to a distance between an outer endpoint of the first groove and the second protrusion's end surface.

55. The sectional material according to claim 48, **characterized in that** when the sectional material pressing member is combined with the sectional material, a gap between the first side and a side surface of the side groove is less than or equal to 2mm.

56. The sectional material according to claim 55, **characterized in that** a side surface of the side groove comprises a lateral protrusion.

57. A photovoltaic module frame, **characterized by** comprising:
a plurality of sectional materials as claimed in any one of claims 26 to 56, each of the sectional material comprising a bearing part for carrying the workpiece to be installed, each of the sectional material comprising a side groove in a side surface, and at least one sectional material pressing member is installed on the side groove.

58. The photovoltaic module frame according to claim 57, **characterized in that** the plurality of sectional materials surround an enclosed area for carrying a photovoltaic module.

59. The photovoltaic module frames according to claim 57, **characterized in that** at least some of the plurality of sectional materials are arranged adjacently, and the adjacently arranged sectional materials share the sectional material pressing member.

**60.** The photovoltaic module frames according to claim 57, **characterized in that** a length of the sectional material pressing member is smaller than a length of the sectional material.

**61.** A photovoltaic system, **characterized by** comprising:

the photovoltaic module frame according to any one of claims 52-55;
a plurality of photovoltaic modules arranged in the photovoltaic module frame.

**62.** A method of assembling a photovoltaic system, **characterized by** including following steps:

installing a first combining portion of a first sectional material pressing member in a side groove of a sectional material with a photovoltaic module;
snapping the side groove of the sectional material with the first sectional material pressing member with a second combining portion of a second sectional material pressing member which is installed on a bracket by a fastener; and
installing the first sectional material pressing member on the bracket through the fastener;
wherein the first sectional material pressing member and the second sectional material pressing member are the sectional material pressing members according to any one of claims 1-10 and 14-25, the sectional material is the sectional material according to any one of claims 26-29 and 31-56.

**63.** The method according to claim 62, **characterized in that** when installing the first combining portion of the first sectional material pressing member in the side groove of the sectional material with the photovoltaic module, install the first sectional material pressing member into the side groove at a predetermined angle relative to the sectional material, and then rotate the first sectional material pressing member until a bottom surface of the first sectional material pressing member is parallel to a bottom surface of the sectional material.

**64.** The method according to claim 62, **characterized in that** when snapping the side groove of the sectional material with the second combining portion of the second sectional material pressing member, snap the sectional material with the second combining portion at a predetermined angle relative to the second sectional material pressing member, and then rotate the sectional material until a bottom surface of the sectional material is parallel to a bottom surface of the second sectional material pressing member.

**65.** The method according to claim 63 or claim 64, **characterized in that** the predetermined angle is between 10-20°.

**66.** The method according to claim 64, **characterized in that** when an upper end of the mouth of the side groove of the sectional material comprises a first convex strip and a lower end of the mouth of the side groove comprises a second convex strip, the fastener does not tighten the second sectional material pressing member so that the second sectional material pressing member has an amount of up and down movement equal to a height of the second convex strip, and after the side groove of the sectional material is engaged with the second combining portion of the second sectional material pressing member, fasten the fastener.

**67.** The method according to claim 64, **characterized in that** when an upper end of the mouth of the side groove of the sectional material comprises a first convex strip and a lower end of the mouth of the side groove comprises a second convex strip, and an end surface of the second protrusion of the second combining portion of the second sectional material pressing member is higher than an end surface of the second protrusion of the first combining portion, fasten the second sectional material pressing member with the fastener before snapping the side groove of the sectional material with the second combining portion of the second sectional material pressing member.

**68.** The method according to claim 67, **characterized in that** in the step of snapping the side groove of the sectional material with a photovoltaic module with the second combining portion of the second sectional material pressing member, firstly lift the sectional material so that a lower endpoint of the first convex strip of the sectional material contacts a floating outer endpoint of the first groove of the second combining portion, then snap the side groove of the sectional material with the second combining portion of the second sectional material pressing member, the floating outer endpoint of the first groove is higher than an outer endpoint of the first groove.

**69.** The method according to claim 67, **characterized in that** when an upper end of the mouth of the side groove of the sectional material which is combined with the second combining portion of the first sectional material pressing member comprises a first convex strip, and a lower end of the mouth of the side groove comprises a second convex strip, the first sectional material pressing member is not tightened when installing the first sectional material pressing member on the bracket by the fastener.

**70.** The method according to claim 67, **characterized in that** when an upper end of the mouth of the side groove of the sectional material which is combined with the second combining portion of the first sectional material pressing member comprises a first convex strip, and a lower end of the mouth of the side groove comprises a second convex strip, and the end surface of the second protrusion of the second combining portion of the second sectional material pressing member is higher than the end surface of the second protrusion of the first combining portion, directly tighten the first sectional material pressing member when installing the first sectional material pressing member on the bracket by the fastener.

**71.** The method according to claim 62, **characterized in that** when the sectional material pressing member is combined with the first sectional material or the second sectional material, a gap between a side surface of the side groove and a side surface of the first sectional material pressing member or the second sectional material pressing member is less than or equal to 2mm.

**72.** A method of assembling a photovoltaic system, **characterized by** including following steps:

installing a first combining portion of a sectional material pressing member into a side groove of a first sectional material with a photovoltaic module;
installing the sectional material pressing member on a bracket by a fastener; and
snapping a side groove of a second sectional material with a second combining portion of the sectional material pressing member;
wherein the first sectional material pressing member and the second sectional material pressing member are the sectional material pressing members according to any one of claims 11-13, the sectional material is the sectional material according to claim 30.

**73.** The method according to claim 72, **characterized in that** when installing the first combining portion of the sectional material pressing member in the side groove of the sectional material with the photovoltaic module, install the sectional material pressing member into the side groove at a predetermined angle relative to the sectional material, and then rotate the sectional material pressing member until a bottom surface of the sectional material pressing member is parallel to a bottom surface of the sectional material.

**74.** The method according to claim 72, **characterized in that** when snapping the side groove of the second sectional material with the second combining portion of the sectional material pressing member, snap the second sectional material with the second combining portion at a predetermined angle relative to the sectional material pressing member, and then rotate the second sectional material until the bottom surface of the second sectional material is parallel to the bottom surface of the sectional material pressing member.

**75.** The method according to claim 73 or claim 74, **characterized in that** the predetermined angle is between 10-20°.

**76.** The method according to claim 72, **characterized in that** when the first sectional material or the second sectional material is combined with the sectional material pressing member, a gap between a side surface of the side groove of the first sectional material or the second sectional material and a side surface of the sectional material pressing member is less than or equal to 2mm.

FIG. 1

FIG. 2

FIG. 3

FIG. 4A

100a

## FIG. 4B

100a'

## FIG. 4C

200a

261
210
253
261
251
220
241
230
251
241
252
262
254
243
252
262
254
242

# FIG. 5A

200a

261
δ
253
251
C
θ
242
253
251
E
h
241
L
A
252
F
252
254
B
262
254
243
255
254

# FIG. 5B

200a

FIG. 5C

FIG. 6A

FIG. 6B

FIG. 7A

FIG. 7B

FIG. 7C

FIG. 8

100b

FIG. 9

200b

FIG. 10

EP 4 447 315 A1

FIG. 11

FIG. 12A

35

211

100b

100b

261

200b

400

# FIG. 12B

253
261
251
242
220
241
243
252
262
254

200c

270

210

230

# FIG. 13A

FIG. 13B

FIG. 14A

100a          100a

211 { 211a                    200c

211b

240

400

FIG. 14B

300                          200c1

100c          100a

112

FIG. 15A

FIG. 15B

FIG. 15C

100c

FIG. 16A

FIG. 16B

100d

FIG. 17A

FIG. 17B

## INTERNATIONAL SEARCH REPORT

International application No.

**PCT/CN2022/137252**

### A. CLASSIFICATION OF SUBJECT MATTER

H02S30/10(2014.01)i

According to International Patent Classification (IPC) or to both national classification and IPC

### B. FIELDS SEARCHED

Minimum documentation searched (classification system followed by classification symbols)

H02S30/-

Documentation searched other than minimum documentation to the extent that such documents are included in the fields searched

Electronic data base consulted during the international search (name of data base and, where practicable, search terms used)

CNTXT, ENTXT, ENTXTC, VEN, WPABSC, IEEE, CNKI: 边框, 槽, 承载, 光伏, 加强, 件, 紧固, 卡条, 开口, 孔, 块, 框架, 连接, 连接件, 连接块, 强度, 缺口, 太阳能, 凸起, 凸条, 突起, 型材, 压, 压件, 压块, hole+, groove+, module+, connect+, frame +, block+, section+, opening+, bundle+, brick+

### C. DOCUMENTS CONSIDERED TO BE RELEVANT

| Category* | Citation of document, with indication, where appropriate, of the relevant passages | Relevant to claim No. |
|---|---|---|
| PX | CN 115589189 A (TRINA SOLAR CO., LTD.) 10 January 2023 (2023-01-10) claims 1-76 | 1-76 |
| PX | CN 218449985 U (TRINA SOLAR CO., LTD.) 03 February 2023 (2023-02-03) claims 1-24 | 2-25 |
| X | CN 208508868 U (ZHEJIANG PERLIGHT SOLAR CO., LTD.) 15 February 2019 (2019-02-15) description, paragraphs 2-66, and figures 1-5 | 1, 14 |
| X | US 2011000519 A1 (WEST JOHN R.) 06 January 2011 (2011-01-06) description, paragraphs 79-228, and figures 3-38 | 26-35, 40-41, 45-47, 52-53, 57-61 |
| Y | CN 208508868 U (ZHEJIANG PERLIGHT SOLAR CO., LTD.) 15 February 2019 (2019-02-15) description, paragraphs 2-66, and figures 1-5 | 2-13, 15-25, 36-39, 42-44, 48-51, 54-56, 62-76 |
| Y | US 2011000519 A1 (WEST JOHN R.) 06 January 2011 (2011-01-06) description, paragraphs 79-228, and figures 3-38 | 2-13, 15-25, 36-39, 42-44, 48-51, 54-56, 62-76 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **02 March 2023** | **02 March 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**

International application No.

**PCT/CN2022/137252**

### C. DOCUMENTS CONSIDERED TO BE RELEVANT

| Category* | Citation of document, with indication, where appropriate, of the relevant passages | Relevant to claim No. |
|---|---|---|
| A | CN 206820704 U (ZHANGJIAGANG GCL SYSTEM INTEGRATION TECHNOLOGY CO., LTD. et al.) 29 December 2017 (2017-12-29)<br>entire document | 1-76 |
| A | CN 210807166 U (CSI SOLAR POWER (SUZHOU) INC. et al.) 19 June 2020 (2020-06-19)<br>entire document | 1-76 |

Form PCT/ISA/210 (second sheet) (July 2022)

| | | | | | | | | |
|---|---|---|---|---|---|---|---|---|
| International application No. | | | | | | | | |
| PCT/CN2022/137252 | | | | | | | | |

| Patent document cited in search report | | | Publication date (day/month/year) | Patent family member(s) | | | Publication date (day/month/year) |
|---|---|---|---|---|---|---|---|
| CN | 115589189 | A | 10 January 2023 | CN | 218449985 | U | 03 February 2023 |
| | | | | CN | 218514329 | U | 21 February 2023 |
| CN | 218449985 | U | 03 February 2023 | CN | 115589189 | A | 10 January 2023 |
| | | | | CN | 218514329 | U | 21 February 2023 |
| CN | 208508868 | U | 15 February 2019 | | None | | |
| US | 2011000519 | A1 | 06 January 2011 | US | 2015155820 | A1 | 04 June 2015 |
| | | | | US | 2016043690 | A1 | 11 February 2016 |
| | | | | US | 2015155821 | A1 | 04 June 2015 |
| | | | | US | 9853597 | B2 | 26 December 2017 |
| | | | | US | 2015222221 | A1 | 06 August 2015 |
| | | | | US | 2011000526 | A1 | 06 January 2011 |
| | | | | US | 8919052 | B2 | 30 December 2014 |
| | | | | US | 2015075590 | A1 | 19 March 2015 |
| | | | | US | 2011000544 | A1 | 06 January 2011 |
| | | | | US | 2015222222 | A1 | 06 August 2015 |
| | | | | US | 2015316292 | A1 | 05 November 2015 |
| | | | | US | 9831818 | B2 | 28 November 2017 |
| | | | | USD | 859967 | S | 17 September 2019 |
| | | | | US | 8991114 | B2 | 31 March 2015 |
| | | | | US | 2011000520 | A1 | 06 January 2011 |
| | | | | US | 8919053 | B2 | 30 December 2014 |
| | | | | CA | 2820935 | A1 | 14 June 2012 |
| | | | | IL | 226835 | A | 31 July 2013 |
| | | | | US | 2011000519 | A1 | 06 January 2011 |
| | | | | US | 2012234378 | A1 | 20 September 2012 |
| | | | | US | 9816731 | B2 | 14 November 2017 |
| | | | | WO | 2012079060 | A2 | 14 June 2012 |
| | | | | WO | 2012079060 | A3 | 10 April 2014 |
| CN | 206820704 | U | 29 December 2017 | | None | | |
| CN | 210807166 | U | 19 June 2020 | | None | | |

Form PCT/ISA/210 (patent family annex) (July 2022)